(19) Europäisches Patentamt
European Patent Office
Office européen des brevets

(11) EP 2 638 089 B1

(12) **EUROPÄISCHE PATENTSCHRIFT**

(45) Veröffentlichungstag und Bekanntmachung des Hinweises auf die Patenterteilung:
**14.10.2015 Patentblatt 2015/42**

(21) Anmeldenummer: **11778632.7**

(22) Anmeldetag: **04.11.2011**

(51) Int Cl.:
***C08G 18/22*** *(2006.01)* ***C08G 18/24*** *(2006.01)*
***C08G 18/67*** *(2006.01)* ***G03F 7/035*** *(2006.01)*
***G11B 7/245*** *(2006.01)*

(86) Internationale Anmeldenummer:
**PCT/EP2011/069418**

(87) Internationale Veröffentlichungsnummer:
**WO 2012/062658 (18.05.2012 Gazette 2012/20)**

(54) **PHOTOPOLYMER-FORMULIERUNG FÜR DIE HERSTELLUNG HOLOGRAPHISCHER MEDIEN**

PHOTOPOLYMER FORMULATION FOR PRODUCING HOLOGRAPHIC MEDIA

FORMULATION DE PHOTOPOLYMÈRE POUR LA FABRICATION DE SUPPORTS HOLOGRAPHIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.11.2010 EP 10190323**

(43) Veröffentlichungstag der Anmeldung:
**18.09.2013 Patentblatt 2013/38**

(73) Patentinhaber: **Bayer Intellectual Property GmbH
40789 Monheim am Rhein (DE)**

(72) Erfinder:
- **HÖNEL, Dennis
53909 Zülpich-Wichterich (DE)**
- **WEISER, Marc-Stephan
51377 Leverkusen (DE)**
- **BRUDER, Friedrich-Karl
47802 Krefeld (DE)**
- **RÖLLE, Thomas
51381 Leverkusen (DE)**
- **FÄCKE, Thomas
51375 Leverkusen (DE)**
- **BERNETH, Horst
51373 Leverkusen (DE)**

(74) Vertreter: **BIP Patents
c/o Bayer Intellectual Property GmbH
Alfred-Nobel-Straße 10
40789 Monheim am Rhein (DE)**

(56) Entgegenhaltungen:
**EP-A1- 2 172 502 EP-A1- 2 172 505
WO-A1-03/102959**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 638 089 B1

## Beschreibung

Die Erfindung betrifft eine Photopolymer-Formulierung umfassend wenigstens eine Polyol-Komponente, eine Polyisocyanat-Komponente, ein Schreibmonomer, einen Photoinitiator und einen Katalysator. Weitere Gegenstände der Erfindung sind ein Verfahren zur Herstellung eines holographischen Mediums, ein nach dem erfindungsgemäßen Verfahren erhältliches holographisches Medium sowie die Verwendung eines erfindungsgemäßen holographischen Mediums zur Herstellung eines Hologramms.

Für die Verwendungen von Photopolymer-Formulierungen spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebener Wellen) durch die lokale Photopolymerisation von z.B. hochbrechenden Acrylate an Orten hoher Intensität im Interferenzfeld in ein Brechungsindexgitter abgebildet. Das Brechungsindexgitter in Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz, im folgenden DE wie Diffraction Efficiency, genannt.

Im einfachsten Fall eines Hologramms, das aus der Überlagerung zweier ebener Wellen entsteht, ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die Lichtmenge des Referenzlichtes die notwendig ist, um das Signal mit einer festen Helligkeit sichtbar zu machen.

Hochbrechende Acrylate sind in der Lage, Brechungsindexgitter mit hoher Amplitude zwischen Bereichen mit niedrigem Brechungsindex und Bereichen mit hohem Brechungsindex zu erzeugen und damit in Photopolymer-Formulierungen Hologramme mit hohem DE und hohem $\Delta n$ zu ermöglichen. Dabei ist zu beachten, dass DE vom Produkt aus $\Delta n$ und der Photopolymerschichtdicke d abhängt. Je größer das Produkt desto größer die mögliche DE (für Reflexionshologramme). Die Breite des Winkelbereiches bei dem das Hologramm z.B. bei monochromatischer Beleuchtung sichtbar (rekonstruiert) wird, hängt nur von der Schichtdicke d ab.

Bei Beleuchtung des Hologramms mit z.B. weißem Licht hängt die Breite des spektralen Bereiches, der zur Rekonstruktion des Hologramms beitragen kann, ebenfalls nur von der Schichtdicke d ab. Dabei gilt je kleiner d desto größer die jeweiligen Akzeptanzbreiten. Will man daher helle und leicht sichtbare Hologramme herstellen, ist ein hohes $\Delta n$ und eine geringe Dicke d anzustreben und zwar so, dass DE möglichst groß wird. Das heißt je höher $\Delta n$ wird, desto mehr Freiraum zur Gestaltung der Schichtdicke d für helle Hologramme erreicht man ohne Verlust an DE. Daher kommt der Optimierung von $\Delta n$ bei der Optimierung von Photopolymer-Formulierungen eine herausragenden Bedeutung zu (P. Hariharan, Optical Holography, 2nd Edition, Cambridge University Press, 1996).

Um ein möglichst hohes $\Delta n$ und DE bei Hologrammen realisieren zu können, sollten grundsätzlich die Matrixpolymere und die Schreibmonomere einer Photopolymer-Formulierung so gewählt werden, dass sie sich in ihren Brechungsindizes stark unterscheiden. Eine Möglichkeit zur Realisierung ist, Matrixpolymere mit einem niedrigen und Schreibmonomere mit einem hohen Brechungsindex zu verwenden. Geeignete Matrixpolymere mit niedrigem Brechungsindex sind z.B. durch Umsetzung einer Polyol- mit einer Polyisocyanat-Komponente erhältliche Polyurethane.

In der WO 2008/125229 A1 ist beispielsweise eine Photopolymer-Formulierung zur Herstellung heller Hologramme beschrieben, die eine Polyol-Komponente, eine Polyisocyanat-Komponente, ein Schreibmonomer auf Acrylatbasis sowie Photoinitiatoren enthaltend einen Coinitiator und einen Farbstoff umfasst. Im ausgehärtetem Zustand sind in der aus Polyol- und Polyisocyanat-Komponente gebildeten Polyurethanmatrix das Schreibmonomer und die Photoinitiatoren räumlich isotrop verteilt eingebettet.

In den europäischen Anmeldungen EP 2 172 502 A1, EP 2 172 505 A1 und in der PCT-Anmeldung WO 03/102959 A1 sind ebenfalls Photopolymer-Formulierungen beschrieben, die eine Polyol-Komponente, eine Polyisocyanat-Komponente, ein Schreibmonomer auf Acrylatbasis sowie Photoinitiatoren enthaltend einen Coinitiator und einen Farbstoff umfassen. Zusätzlich ist beschrieben, dass Katalysatoren wie Zinnoctoat und Eisen(III)-acetylacetonat in den Formulierungen vorhanden sein können.

Aus der EP 2 218 744 A ist wiederum ein großtechnisches Verfahren für die Herstellung von Medien, insbesondere in der Form von Filmen, aus derartigen Photopolymer-Formulierungen bekannt. Bei dem hier beschriebenen Verfahren wird aus der Polyol-Komponente, der Polyisocyanat-Komponente, den Schreibmonomeren und den Photoinitiatoren eine Mischung hergestellt, die Mischung auf ein Trägermaterial aufgebracht und dort ausgehärtet. Während der Aushärtung wird die Mischung erhitzt, um die Reaktion der Polyol-Komponente mit der Polyisocyanat-Komponente zu den die Matrix bildenden Polyurethanen zu beschleunigen. Mit zunehmender Temperatur kann dabei grundsätzlich die Aushärtung beschleunigt werden. Allerdings reagieren bei Temperaturen oberhalb 90 °C nicht nur die Polyol-Komponente und die Polyisocyanat-Komponente miteinander, sondern es kann zusätzlich auch zu einer unerwünschten thermischen Vernetzung der Schreibmonomere kommen. Daher kann die Härtung nicht bei Temperaturen wesentlich oberhalb von 90 °C durchgeführt werden.

Um auch in dem Temperaturbereich kleiner 90 °C eine ausreichende Vernetzung der Polyurethanmatrix sicher zu stellen, muss die Dauer des Aushärtungsschritts entsprechend verlängert werden. Bei einem kontinuierlichen Herstellungsprozess wie dem in der EP 2 218 744 A beschriebenen Rolle-zu-Rolle-Verfahren bedeutet dies, dass entweder die Produktionsgeschwindigkeit reduziert oder die Aushärtungsstrecke, in der der Film erhitzt wird, erheblich verlängert werden muss. Beides ist unter Kostengesichtspunkten nachteilig.

Grundsätzlich ist es bekannt, dass die Urethanbildungsreaktion durch den Zusatz von Katalysatoren beschleunigt werden kann. So sind auch in der EP 2 218 744 A derartige Katalysatoren beschrieben. Allerdings wird durch den Einsatz dieser Katalysatoren die Topfzeit der Photopolymer-Formulierungen, d.h. die Zeit, in der die Photopolymer-Formulierung nach dem Vermischen der Komponenten bei Raumtemperatur noch ohne Probleme auf das Trägermaterial aufgebracht werden kann, erheblich reduziert. Dies führt dazu, dass die Viskosität der Photopolymer-Formulierung während des Auftragens auf Trägermaterial bereits stark ansteigt, so dass ein gleichmäßiges Auftragen kaum noch möglich ist oder es zumindest zu Fehlstellen im fertigen Medium kommt.

Aufgabe der vorliegenden Erfindung war daher, eine Photopolymer-Formulierung der eingangs genannten Art bereit zu stellen, die einerseits bei Raumtemperatur eine möglichst lange Topfzeit aufweist und andererseits bei einer Temperatur im Bereich von 90 °C möglichst schnell aushärtet.

Diese Aufgabe ist bei der erfindungsgemäßen Photopolymer-Formulierung dadurch gelöst, dass sie eine Aktivierungstemperatur von ≥ 8300 K aufweist, wobei die Aktivierungstemperatur wird bestimmt wird, indem aus der Polyol-Komponente, der Polyisocyanat-Komponente, dem Schreibmonomer und dem Katalysator eine Mischung hergestellt, von der Mischung jeweils das Speichermodul *G*' und das Verlustmodul *G*" über eine Messzeit *t*, mindestens bis die Bedingung des Gelpunktes $G' = G'' = G_{Gel}$ zur Zeit $t_{Gel}$ erreicht ist, bei Temperaturen *T* = 303 K, 313 K, 328 K, 343 K und 353 K mit einem Platte - Platte Messsystem eines Rheometers bei einem Plattenabstand von 250 μm im Messmodus Oszillation bei einer konstanten Frequenz *f* von 10 Hz und einer geregelten Deformationsamplitude von 10% bestimmt, eine logarithmische Auftragung von $t_{Gel}$ gegen die jeweilige inverse absolute Temperatur 1/T, bei der $t_{Gel}$ bestimmt wurde, erstellt und aus der Auftragung mittels linearer Regression die Aktivierungstemperatur gemäß der Formel

$$\ln\left(t_{Gel}/\min\right) = T_{Akt}/T + A$$

als Steigung der Geraden ermittelt wird.

So wurde überraschenderweise gefunden, dass Photopolymer-Formulierungen mit einer Aktivierungstemperatur ≥ 8300 K bei Raumtemperatur, d.h. insbesondere im Temperaturbereich 15 bis 40 °C eine sehr lange Topfzeit haben und entsprechend gut auf ein Trägermaterial aufgebracht werden können. Umgekehrt können diese Photopolymer-Formulierungen bei einer Temperatur im Bereich von 90 °C, d.h. insbesondere im Temperaturbereich von 60 bis 100 °C schnell ausgehärtet werden. Es sind also beispielsweise in kontinuierlichen Herstellungsverfahren wie dem Rolle-zu-Rolle-Verfahren hohe Produktionsgeschwindigkeiten, bzw. kurze Aushärtungsstrecken möglich, da das Photopolymer schnell blockfest und damit wickelbar wird.

Die aus den Anmeldungen EP 2 172 502 A1, EP 2 172 505 A1 und WO 03/102959 A1 bekannten Zinnoctoat und Eisen(III)-acetylacetonat enthaltenden Photopolymer-Formulierungen weisen bei Raumtemperatur Aktivierungstemperaturen < 8300 K auf, wie dies durch die entsprechenden Vergleichsbeispiele im experimentellen Teil der vorliegenden Anmeldung belegt ist. Sie bieten daher auch nicht die oben aufgeführten technischen Vorteile der erfindungsgemäßen Formulierungen.

Gemäß einer ersten bevorzugten Ausführungsform der Erfindung ist vorgesehen, dass die Aktivierungstemperatur der Photopolymer-Formulierung ≥ 8700 K, bevorzugt > 9000 K, besonders bevorzugt ≥ 9300 K und ganz besonders bevorzugt ≥ 9500 K ist. In diesem Fall härtet die Photopolymer-Formulierung bei einer Temperatur im Bereich von 90 °C besonders schnell aus.

Als Polyisocyanat-Komponente a) können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mit verwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)-methan und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatomethyl-1,8-octandiisocyanat (TIN), 2,4- und/-oder 2,6-Toluen-diisocyanat.

Als isocyanatreaktive Verbindungen a2) zum Aufbau der Prepolymere werden bevorzugt OHfunktionelle Verbindungen eingesetzt. Diese sind analog den OH-funktionellen Verbindungen wie sie nachfolgend für die Komponente b) beschrieben sind.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, amin-terminierte Polymere mit zahlenmittleren Molmassen bis 10000 g/Mol oder deren beliebige Gemische untereinander.

Zur Herstellung von Biuretgruppen-haltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und oligomeren oder polymeren Polyolen oder Polyaminen mit zahlenmittleren Molmassen von 500 bis 8500 g/Mol und ganz besonders bevorzugt sind Allophanate aus HDI oder TMDI und difunktionellen Polyetherpolyolen mit zahlenmittleren Molmassen von 1000 bis 8200 g/Mol.

Bevorzugt weisen die vorstehend beschriebenen Prepolymere Restgehalte an freiem monomeren Isocyanat von weniger als 1 Gew.-%, besonders bevorzugt weniger als 0.5 Gew.-% und ganz besonders bevorzugt weniger als 0.2 Gew.-% auf.

Selbstverständlich kann die Polyisocyanat-Komponente anteilsmäßig neben den beschriebenen Prepolymeren weitere Isocyanatkomponenten enthalten. Hierfür kommen aromatische, araliphatische, aliphatische und cycloaliphatische Di-, Tri- oder Polyisocyanate in Betracht. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Polyisocyanat-Komponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigte Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt. Besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxidmono(meth)acrylate, Polyalkylenoxidmono(meth)acrylate, Poly(ε-caprolacton)mono(meth)acrylate, wie z.B. Tone® M100 (Dow, USA), Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten an der Isocyanatkomponente a), die teilweise mit isocyanat-reaktiven ethylenisch ungesättigten Verbindungen umgesetzt sind beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Polyisocyanat-Komponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Besonders bevorzugt ist, wenn die Polyisocyanat-Komponente ein aliphatisches Polyisocyanat oder ein aliphatisches Prepolymer und bevorzugt ein aliphatisches Polyisocyanat oder Prepolymer mit primären NCO-Gruppen ist.

Als Polyol-Komponente b) können an sich alle polyfunktionellen, isocyanatreaktiven Verbindungen eingesetzt werden, die im Mittel wenigstens 1.5 isocyanatreaktive Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität $> 2$ erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für geeignete Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität $\geq 2$ beispielsweise der vorstehend genannten Art erhalten werden können.

Solche Polyesterpolyole haben bevorzugt zahlenmittlere Molmassen von 400 bis 4000 g/Mol, besonders bevorzugt von 500 bis 2000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität $\geq 2$, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alkylenoxidanteil nicht höher als 80 Gew.-% ist. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten $C_3$- und $C_4$-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1.

Daneben sind als Bestandteile der Polyol-Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Besonders bevorzugt ist auch, wenn die Polyolkomponente primäre OH-Gruppen aufweist und ganz bevorzugt ein difunktioneller Polyether- oder Polyester oder ein Polyether-Polyester-Blockcopolymer mit primären OH-Gruppen ist.

Besonders bevorzugt ist eine Kombination aus Komponente a) und b) bei der Herstellung der Matrixpolymere bestehend aus Additionsprodukten von Butyrolacton, ε-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Ganz besonders bevorzugt sind Additionsprodukte von ε-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

Als Schreibmonomer B) werden ein oder mehrere verschiedene Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind, eingesetzt. Bevorzugt sind die Schreibmonomere Acrylate und / oder Methacrylate. Ganz besonders bevorzugt sind Urethanacrylate und Urethan(meth)acrylate.

Bei einer weiteren bevorzugten Ausführungsform ist vorgesehen, dass das Schreibmonomer wenigstens ein mono- und / oder ein multifunktionales Schreibmonomer umfasst, wobei es sich insbesondere um mono- und multifunktionelle Acrylat-Schreibmonomere handeln kann. Besonders bevorzugt kann das Schreibmonomer wenigstens ein monofunktionelles und ein multifunktionelles Urethan(meth)acrylat umfassen.

Bei den Acrylat-Schreibmonomeren kann es sich insbesondere um Verbindungen der allgemeinen Formel (I)

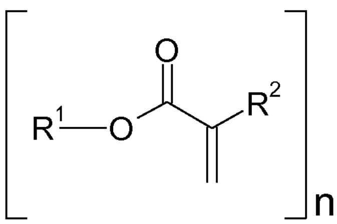

(I)

handeln, bei denen n≥1 und n≤4 ist und $R^1$, $R^2$ unabhängig voneinander Wasserstoff, lineare, verzweigte, cyclische oder heterocyclische unsubstituierte oder gegebenenfalls auch mit Heteroatomen substituierte organische Reste sind. Besonders bevorzugt ist $R^2$ Wasserstoff oder Methyl und/oder $R^1$ ein linearer, verzweigter, cyclischer oder heterocyclischer unsubstituierter oder gegebenenfalls auch mit Heteroatomen substituierter organischer Rest.

Ebenso ist es möglich, dass weitere ungesättigte Verbindungen wie $\alpha,\beta$-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, $\alpha$-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure zugesetzt werden. Bevorzugt sind aber Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenylmethacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate, um nur eine Auswahl verwendbarer Acrylate und Methacrylate zu nennen.

Unter Urethanacrylaten versteht man Verbindungen mit mindestens einer Acrylsäureestergruppe, die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können. Beispiele hierfür verwendbarer Isocyanat-funktionelle Verbindungen sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4-und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, m-Methylthiophenylisocyanat, Triphenylmethan-4,4',4''-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise Verbindungen in Betracht wie 2-Hydroxyethyl(meth)acrylat, Polyethylenoxid-mono(meth)acrylate, Polypropylenoxidmono(meth)acrylate, Polyalkylenoxidmono(meth)-acrylate, Poly($\varepsilon$-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly($\varepsilon$-caprolacton)mono(meth)acrylate. Darüber hinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und m-Methylthiophenylisocyanat mit alkoholfunktionellen Acrylaten wie Hydroxyethyl(meth)acrylat, Hydroxypropyl(meth)acrylat und Hydroxybutyl(meth)acrylat.

Die eingesetzten Photoinitiatoren C) sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

Die Photoinitiatoren C) können insbesondere einen anionischen, kationischen oder neutralen Farbstoff und einen Coinitiator umfassen.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxide, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon.

Auch die in der EP 0 223 587 A beschriebenen Photoinitiatorsysteme, bestehend aus einer Mischung aus einem Ammoniumarylborat und einem oder mehreren Farbstoffen, können als Photoinitiator eingesetzt werden. Als Ammoniumarylborat eignen sich beispielsweise Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat, Tetramethylammonium Triphenylbenzylborat, Tetra(n-hexyl)ammonium (sec-Butyl)triphenylborat, 1-Methyl-3-octylimidazolium Dipentyldiphenylborat und Tetrabutylammonium Tris-(3-Chlor-4-methylphenyl)-hexylborat (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind Chrom-Salze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152) zu nennen. Eine weitere Möglichkeit der anionischen Polymerisation besteht in der Verwendung von Farbstoffen, wie Kristallviolett Leukonitril oder Malachit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch bei Abwesenheit eines Wasserstoff-Donors ein Kation erzeugten, das die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren $SbF_6^-$, $AsF_6^-$ oder $PF_6^-$. Für den Einsatz in Beschichtung dünner Filme sind diese Verbindungen i.d.R wenig geeignet, da durch den nach der Belichtung freigesetzten Stickstoff die Oberflächegüte herabgesetzt wird (pinholes) (Li et al., Polymeric Materials Science and Engineering, 2001, 84, 139).

Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalanion, welches sich durch H-Abstraktion stabilisiert und ein Proton freisetzt und dann die kationische Polymerisation startet (Dektar et al. J. Org. Chem. 1990, 55, 639; J. Org. Chem., 1991, 56. 1838). Dieser Mechanimus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls $SbF_6^-$, $AsF_6^-$ oder $PF_6^-$. Ansonsten ist in dieser Strukturklasse die Wahl der Substitution des Aromaten recht frei und im wesentlichen durch die Verfügbarkeit geeigneter Startbausteine für die Synthese bestimmt.

Bei den Sulfonium-Salzen handelt es sich um Verbindungen, die nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt.

Da die Eigenabsorption von Iodonium- und Sulfonium-Salze bei <300 nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivate (Hua et al, Macromolecules 2001, 34, 2488-2494).

Es kann vorteilhaft sein, Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren C) sind Mischungen aus Tetrabutylammonium Tetrahexylborat, Tetrabutylammonium Triphenylhexylborat, Tetrabutylammonium Triphenylbutylborat, Tetrabutylammonium Tris-(3-fluorphenyl)-hexylborat ([191726-69-9], CGI 7460, Produkt der BASF SE, Basel, Schweiz) und Tetrabutylammonium Tris-(3-Chlor-4-methylphenyl)-hexylborat ([1147315-11-4], CGI 909, Produkt der BASF SE, Basel, Schweiz) mit kationischen Farbstoffen wie sie beispielsweise in H. Berneth in Ullmann's Encyclopedia of Industrial Chemistry, Cationic Dyes, Wiley-VCH Verlag,

2008 beschrieben sind. Vorzugsweise entsprechen diese kationischen Farbstoffe der Formel $F^+An^-$.

Unter kationischen Farbstoffen der Formel $F^+$ werden bevorzugt solche der folgenden Klassen verstanden: Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di- und Trimethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Mit $An^-$ ist ein Anion gemeint. Bevorzugte Anionen $An^-$ sind insbesondere $C_8$- bis $C_{25}$-Alkansulfonat, vorzugsweise $C_{13}$- bis $C_{25}$-Alkansulfonat, $C_3$- bis $C_{18}$-Perfluoralkansulfonat, vorzugsweise $C_4$- bis $C_{18}$-Perfluoralkansulfonat, $C_9$- bis $C_{25}$-Alkanoat, $C_9$- bis $C_{25}$-Alkenoat, $C_8$- bis $C_{25}$-Alkylsulfat, vorzugsweise $C_{13}$- bis $C_{25}$-Alkylsulfat, $C_8$- bis $C_{25}$-Alkenylsulfat, vorzugsweise $C_{13}$- bis $C_{25}$-Alkenylsulfat, $C_3$- bis $C_{18}$-Perfluoralkylsulfat, vorzugsweise $C_4$- bis $C_{18}$-Perfluoralkylsulfat, Polyethersulfate basierend auf mindestens 4 Äquivalenten Ethylenoxid und/oder Äquivalenten 4 Propylenoxid, Bis-$C_4$- bis $C_{25}$-Alkyl-, $C_5$- bis $C_7$-Cycloalkyl-, $C_3$- bis $C_8$-Alkenyl- oder $C_7$- bis $C_{11}$-Aralkyl-sulfosuccinat, durch mindestens 8 Fluoratome substituiertes Bis-$C_2$- bis $C_{10}$-Alkyl-sulfosuccinat, $C_8$- bis $C_{25}$-Alkyl-sulfoacetate, durch mindestens einen Rest der Gruppe Halogen, $C_4$- bis $C_{25}$-Alkyl, Perfluor-$C_1$- bis $C_8$-Alkyl und/oder $C_1$- bis $C_{12}$-Alkoxycarbonyl substituiertes Benzolsulfonat, ggf. durch Nitro, Cyano, Hydroxy, $C_1$- bis $C_{25}$-Alkyl, $C_1$- bis $C_{12}$-Alkoxy, Amino, $C_1$- bis $C_{12}$-Alkoxycarbonyl oder Chlor substituiertes Naphthalin- oder Biphenylsulfonat, ggf. durch Nitro, Cyano, Hydroxy, $C_1$- bis $C_{25}$-Alkyl, $C_1$- bis $C_{12}$-Alkoxy, $C_1$- bis $C_{12}$-Alkoxycarbonyl oder Chlor substituiertes Benzol-, Naphthalin- oder Biphenyldisulfonat, durch Dinitro, $C_6$- bis $C_{25}$-Alkyl, $C_4$- bis $C_{12}$-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$- bis $C_{12}$-alkandicarbonsäureester, Bis-(sulfo-$C_2$- bis $C_6$-alkyl)-itaconsäureester, (Sulfo-$C_2$- bis $C_6$-alkyl)-$C_6$- bis $C_{18}$-alkancarbonsäureester, (Sulfo-$C_2$- bis $C_6$-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, $C_4$- bis $C_{12}$-Alkyl-triphenylborat, deren Phenyl- oder Phenoxy-Reste durch Halogen, $C_1$- bis $C_4$-Alkyl und/oder $C_1$- bis $C_4$-Alkoxy substituiert sein können, $C_4$- bis $C_{12}$-Alkyl-trinaphthylborat, Tetra-$C_1$- bis $C_{20}$-alkoxyborat, 7,8- oder 7,9-Dicarba-nido-undecaborat(1-) oder (2-), die gegebenenfalls an den B- und/oder C-Atomen durch eine oder zwei $C_1$- bis $C_{12}$-Alkyl- oder Phenyl-Gruppen substituiert sind, Dodecahydro-dicarbadodecaborat(2-) oder B-$C_1$- bis $C_{12}$-Alkyl-C-phenyl-dodecahydro-dicarbadodecaborat(1-) steht, wobei bei mehrwertigen Anionen wie Naphthalindisulfonat $An^-$ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl sustituiert sein können.

Besonders bevorzugte Anionen sind Sec-$C_{11}$- bis $C_{18}$-Alkansulfonat, $C_{13}$- bis $C_{25}$-Alkylsulfat, verzweigtes $C_8$- bis $C_{25}$-Alkylsulfat, ggf. verzweigtes Bis-$C_6$- bis $C_{25}$-Alkylsulfosuccinat, sec-oder tert.-$C_4$- bis $C_{25}$-Alkylbenzolsulfonat, sulfonierte oder sulfatierte, ggf. mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$- bis $C_{12}$-alkandicarbonsäureester, (Sulfo-$C_2$- bis $C_6$-alkyl)-$C_6$-bis $C_{18}$-alkancarbonsäureester, durch bis zu 12 Halogenreste substituiertes Triscatecholphosphat, Cyanotriphenylborat, Tetraphenoxyborat.

Bevorzugt ist auch, wenn das Anion $An^-$ des Farbstoffs einem AClogP im Bereich von 1-30, besonders bevorzugt im Bereich von 1-12 und insbesondere bevorzugt im Bereich von 1-6,5 aufweist. Der AClogP wird nach J. Comput. Aid. Mol. Des. 2005, 19, 453; Virtual Computational Chemistry Laboratory, http://www.vcclab.org berechnet.

Besonders bevorzugt sind Farbstoffe $F^+An^-$ mit einer Wasseraufnahme ≤5 Gew.-%.

Die Wasseraufnahme ergibt sich aus der Formel (F-1)

$$W = (m_f/m_t - 1)*100\% \quad (F\text{-}1),$$

worin $m_f$ die Masse des Farbstoffs nach Wassersättigung und $m_t$ die Masse des getrockneten Farbstoffs sind. $m_t$ wird durch Trocknen einer bestimmten Farbstoffmenge bis zur Massenkonstanz, beispielsweise bei erhöhter Temperatur im Vakuum ermittelt. $m_f$ wird durch Stehen einer bestimmtem Farbstoffmenge an der Luft bei einer definierten Luftfeuchtigkeit bis zur Gewichtskonstanz bestimmt.

In einer weiteren bevorzugten Ausführungsform sind die Photoinitiatoren C) Mischungen aus Tetrabutylammonium Tetrahexylborat, Tetrabutylammonium Triphenylhexylborat, Tetrabutylammonium Triphenylbutylborat, Tetrabutylammonium Tris-(3-fluorphenyl)-hexylborat ([191726-69-9], CGI 7460, Produkt der BASF SE, Basel, Schweiz) und Tetrabutylammonium Tris-(3-Chlor-4-methylphenyl)-hexylborat ([1147315-11-4], CGI 909, Produkt der BASF SE, Basel,

Schweiz) mit Farbstoffen wie Astrazon Orange G, Basic Blue 3, Basic Orange 22, Basic Violett 7, Methylenblau, Neu Methylenblau, Azur A, Pyrillium I, Safranin O, Cyanin, Gallocyanin, Brilliant Grün, Kristallviolett, Ethylviolett und Thionin. Besonders bevorzugt weisen die vorstehend genannten Farbstoffe die oben aufgeführten Anionen auf.

Ganz besonders bevorzugt ist, wenn der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bei dem Katalysator c) kann es sich insbesondere um Verbindungen der allgemeinen Formel (II)

$RSnL_3$ (II)

handeln, in der

R ein linearer oder verzweigter, gegebenenfalls mit Heteroatomen, insbesondere mit Sauerstoff, auch in der Kette substituierter Alkylrest mit 1 - 30 C-Atomen ist und

L jeweils unabhängig voneinander $^{-}O_2C\text{-}R^3$ Gruppen sind, bei denen $R^3$ ein linearer oder verzweigter, gegebenenfalls mit Heteroatomen, insbesondere mit Sauerstoff, auch in der Kette substituierter Alkylrest mit 1 - 30 C-Atomen, ein Alkenylrest mit 2 - 30 C-Atomen oder ein beliebiger substituierter oder unsubstituierter gegebenenfalls polycyclischer aromatischer Ring mit oder ohne Heteroatomen ist.

Besonders bevorzugt ist hier, wenn R ein linearer oder verzweigter Alkylrest mit 1 - 12 C-Atomen, besonders bevorzugt ein Methyl-, Ethyl-, Propyl, *n*-, *i*-, *t*-Butyl-, *n*-Octyl-Rest und ganz besonders bevorzugt ein *n*-, *i*-, *t*-Butyl-Rest ist und / oder $R^3$ ein linearer oder verzweigter, gegebenenfalls mit Heteroatomen, insbesondere mit Sauerstoff, auch in der Kette substituierter Alkyl-Rest mit 1 - 17 C-Atomen oder Alkenyl-Rest mit 2 - 17 C-Atomen, besonders bevorzugt ein linearer oder verzweigter Alkyl- oder Alkenylrest mit 3 - 13 C-Atomen. ganz besonders bevorzugt ein linearer oder verzweigter Alkyl- oder Alkenylrest mit 5 - 11 C-Atomen ist. Insbesondere sind alle L gleich.

Weitere geeignete Katalysatoren sind beispielsweise Verbindungen der allgemeinen Formel (III) oder (IV)

$Bi(III)M_3$ (III),

$Sn(II)M_2$ (IV),

in der M jeweils unabhängig voneinander $-O_2C\text{-}R^4$ Gruppen sind, bei denen $R^4$ ein gesättigter oder ungesättiger oder mit Heteroatomen substituierter $C_1$- bis $C_{19}$-Alkylrest oder $C_2$- bis $C_{19}$-Alkenylrest, insbesondere ein $C_6$- bis $C_{11}$-Alkylrest und besonders bevorzugt ein $C_7$- bis $C_9$-Alkylrest oder ein gegebenenfalls aromatisch oder mit Sauerstoff oder Stickstoff beliebig substituierter $C_1$- bis $C_{18}$-Alkylrest ist, wobei in den Formel (III) und (IV) M nicht gleichbedeutend sein muss.

Weitere geeignete Katalysatoren sind beispielsweise Verbindungen der allgemeinen Formel (V)

$FeQ_3$ (V),

in der Q jeweils unabhängig voneinander organische Anionen der Formel (Va) sind,

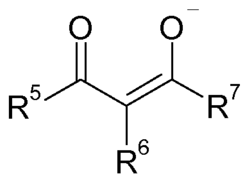

(Va)

bei denen $R^5$ und $R^7$ jeweils unabhängig voneinander ein gegebenenfalls mit Heteroatomen substituierter $C_1$- bis $C_{18}$-Alkylrest oder $C_2$-$C_{18}$ Alkenylrest, insbesondere ein $C_1$- bis $C_{10}$-Alkylrest und besonders bevorzugt ein $C_1$- bis $C_4$-Alkylrest ist oder $R^5$ und $R^6$ gemeinsam eine Brücke, beispielsweise aus $-CH_2\text{-}CH_2\text{-}CH_2-$, $-CH_2\text{-}CH_2\text{-}CH_2\text{-}CH_2-$, $-CH_2\text{-}CH_2\text{-}CH_2\text{-}CH_2\text{-}CH_2-$, -CH=CH-CH=CH- bilden oder ein gegebenenfalls mit Heteroatomen substituierter aromatischer oder hetero-aromatischer Ring sind und $R^6$ Methyl oder Wasserstoff ist.

Besonders bevorzugt ist daher, wenn der Urethanisierungskatalysator c) aus der Gruppe der oben genannten Verbindungen der Formeln (II), (III), (IV) und/oder (V) ausgewählt wird.

Ganz besonders bevorzugt ist daher, wenn der Urethanisierungskatalysator c) aus der Gruppe der oben genannten Verbindungen der Formeln (II), (III) und/oder (IV) ausgewählt wird.

Unter Alkylrest oder gegebenenfalls aromatisch oder mit Sauerstoff oder Stickstoff beliebig substituierter Alkylrest sind lineare oder verzweigte Alkylreste zu verstehen, wie. z. B. Methyl, Ethyl, die isomeren Propyle, die isomeren

Butyle, die isomeren Pentyle, die isomeren Hexyle, die isomeren Octyle, die isomeren Decyle, die isomeren Dodecyle, die isomeren Hexadecyle, die isomeren Heptadecyle, die isomeren Octadecyle, Cyclohexylmethyl, Methoxyethyl, Methoxypropyl, Methoxybutyl, Ethoxyethyl, Ethoxypropyl, Ethoxybutyl, Ethoxyethoxyethyl, Dimethylaminoethyl, Dimethylaminobutyl, N-Morpholinomethyl, N-Morpholinoethyl, Benzyl, Phenethyl, Phenylpropyl, Naphthylmethyl, Pyridylmethyl, Pyridylethyl.

Unter einem Alkenylrest ist ein wie oben beschriebener Alkylrest mit mindestens 3 Kohlenstoff-Atomen und mindestens einer Kohlenstoff-Doppelbindung zu verstehen, Beispiele hierfür sind, Allyl, Homoally, die isomeren Pentenyle, die isomeren Hexenyle, die isomeren Octenyle, die isomeren Decenyle, die isomeren Undecenyle, die isomeren Heptadecenyle, die isomeren Heptadecadienyle.

Unter beliebiger substituierter oder unsubstituierter gegebenenfalls polycyclischer aromatischer Ring mit oder ohne Heteroatomen sind beispielsweise zu verstehen: Phenyl, Tolyl, Xylyl, Chlorphenyl, Anisyl, Nitrophenyl, Naphthyl, Pyridyl, Thienyl.

Beispiele geeigneter Katalysatoren c) sind Methylzinn-tris(2-ethylhexanoat), Ethylzinn-tris(2-ethylhexanoat), Propylzinn-tris(2-ethylhexanoat), Butylzinn-tris(2-ethylhexanoat), Hexylzinn-tris(2-ethylhexanoat), Methylzinn-tris(acetat), Ethylzinn-tris(acetat), Propylzinn-tris(acetat), Butylzinn-tris(acetat), Hexylzinn-tris(acetat), Methylzinn-tris(propionat), Ethylzinn-tris(propionat), Propylzinn-tris(propionat), Butylzinn-tris(propionat), Hexylzinn-tris(propionat), Methylzinn-tris(butyrat), Ethylzinn-tris(butyrat), Propylzinn-tris(butyrat), Butylzinn-tris(butyrat), Hexylzinn-tris(butyrat), Methylzinn-tris(hexanoat), Ethylzinn-tris(hexanoat), Propylzinn-tris(hexanoat), Butylzinn-tris(hexanoat), Hexylzinn-tris(hexanoat), Methylzinn-tris(decanoat), Ethylzinn-tris(decanoat), Propylzinn-tris(decanoat), Butylzinn-tris(decanoat), Hexylzinn-tris(decanoat), Bismuth(III) tris(hexanoat), Bismut(III) tris(heptanoat), Bismut(III) tris(octanoat), Bismut(III) tris(nonanoat), Bismut(III) tris(decanoat), Bismut(III) tris(dodecanoat), Bismut(III) tris(neodecanoat), Bismut(III) subgallat, Bismut(III) subsalicylat, Zinn(II) bis(acetat), Zinn(II) bis(propionat), Zinn(II) bis(butyrat), Zinn(II) bis(pentanoat), Zinn(II) bis(hexanoat), Zinn(II) bis(2-ethylhexanoat), Zinn(II) bis(nonanoat), Zinn(II) bis(decanoat), Zinn(II) bis(dodecanoat), Zinn(II) bis(oleat), Eisen(III) tris((2Z)-3-hydroxy-1,3-diphenylprop-2-en-1-on), Eisen(III) tris(3-hydroxy-5-(4-methylphenyl)cyclohex-2-en-1-on), Eisen(III) tris(5-hexyl-3-hydroxycyclohex-2-en-1-on), Eisen(III) tris((3E)-1,1,1,5,5,5-hexafluoro-4-hydroxypent-3-en-2-on), Eisen[III] tris-acetylacetonat, Eisen(III) tris(3-hydroxycyclopent-2-en-1-on), Eisen(III) tris((4E)-5-hydroxyhex-4-en-3-on), Eisen(III) tris((3Z)-4-hydroxy-4-phenylbut-3-en-2-on), Eisen(III) tris((2Z)-3-(3-chlorophenyl)-1-cyclopropyl-3-hydroxyprop-2-en-1-on), Eisen(III) tris((1Z)-1-(4-fluorophenyl)-1-hydroxy-4-methylpent-1-en-3-on), Eisen(III) tris((2Z)-1-(2,4-dichlorophenyl)-4,4,4-trifluoro-3-hydroxybut-2-en-1-on), Eisen(III) tris((2Z)-1-(4-chlorophenyl)-4,4,4-trifluoro-3-hydroxybut-2-en-1-on), Eisen(III) tris(-acetyl-3-oxo-N-phenylbutanethioamid), Eisen(III) tris(methyl 3-acetyl-4-oxopentanoat), Eisen(III) tris(-[(methylsulfanyl)methyl]pentane-2,4-dion), Eisen(III) tris(3-(4-nitrophenyl)pentane-2,4-dion), Eisen(III) tris(3-acetylhexane-2,5-dion), Eisen(III) tris(4-acetyl-5-oxohexanenitril), Eisen(III) tris(3-[(phenylsulfonyl)methyl]pentane-2,4-dion), Eisen(III) tris(3-fluoropentane-2,4-dion), Eisen(III) tris(3-benzylpentane-2,4-dion), Eisen(III) tris(3-(pyridin-3-ylmethyl)pentane-2,4-dion), Eisen(III) tris(3-tert-butylpentane-2,4-dion), Eisen(III) tris(3-propylpentane-2,4-dion), Eisen(III) tris(3-phenylpentane-2,4-dion), Eisen(III) tris(3-pentylpentane-2,4-dion), Eisen(III) tris(3-butylpentane-2,4-dion), Eisen(III) tris(3-(4-chlorobenzyl)pentane-2,4-dion), Eisen(III) tris(3-methylpentane-2,4-dion).

Besonders bevorzugte Katalysatoren c) sind Butylzinn-tris(2-ethylhexanoat), Eisen [III] - tris-acetylacetonat, Bismuth(III) tris(2-ethylhexanoat), und Zinn(II) bis(2-ethylhexanoat).

Gemäß einer weiteren bevorzugten Ausführungsform ist vorgesehen, dass die Photopolymer-Formulierung zusätzlich Weichmacher D) und besonders bevorzugt Urethane als Weichmacher enthält, wobei die Urethane insbesondere mit wenigstens einem Fluoratom substituiert sein können.

Bevorzugt können die Urethan-Weichmacher die allgemeine Formel (VI)

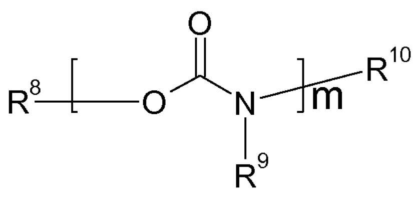

(VI)

haben, in der m≥1 und m≤8 ist und $R^8$, $R^9$, $R^{10}$ unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste $R^8$, $R^9$, $R^{10}$ mit wenigstens einem Fluoratom substituiert ist und besonders bevorzugt $R^8$ ein organischer Rest mit mindestens einem Fluoratom ist. Besonders bevorzugt ist $R^8$ ein linearer, verzweigter, cyclischer oder heterocyclischer unsubstituierter oder gegebenenfalls auch mit Heteroatomen wie beispielsweise Fluor substituierter organischer Rest.

Die erfindungsgemäßen Photopolymer-Formulierungen können bevorzugt

10 bis 84,999 Gew.-%, der Polyol-Komponente a),

2 bis 30 Gew.-%, der Polyisocyanat-Komponente b),

10 bis 60 Gew.-%, des Schreibmonomers B),

0,001 bis 10 Gew.-%, des Photoinitiators C),

0,001 bis 4 Gew.-%, des Katalysators c) und gegebenenfalls

0 bis 30 Gew.-%, des Weichmachers D)

umfassen, wobei sich die Summen der Gewichtsprozente stets zu hundert Gewichtsprozent ergänzen.

Ganz besonders bevorzugt kann die Photopolymer-Formulierung

25 bis 70 Gew.-%, der Polyol-Komponente a),

5 bis 25 Gew.-%, der Polyisocyanat-Komponente b),

25 bis 50 Gew.-%, des Schreibmonomers B),

0,01 bis 5 Gew.-%, des Photoinitiators C),

0,01 bis 2 Gew.-%, des Katalysators c) und gegebenenfalls

0 bis 25 Gew.-%, des Weichmachers D)

umfassen, wobei sich die Summen der Gewichtsprozente stets zu hundert Gewichtsprozent ergänzen.

Gegenstand der Erfindung ist auch ein holographisches Medium, enthaltend eine erfindungsgemäße Photopolymer-Formulierung oder erhältlich unter Verwendung einer erfindungsgemäßen Photopolymer-Formulierung. Noch ein weiterer Gegenstand der Erfindung ist die Verwendung einer erfindungsgemäßen Photopolymer-Formulierung zur Herstellung holographischer Medien.

Die erfindungsgemäßen Photopolymer-Formulierungen können insbesondere zur Herstellung holographischer Medien verwendet werden.

Gegenstand der Erfindung ist daher auch ein Verfahren zur Herstellung eines holographischen Mediums, bei dem

(I) eine erfindungsgemäße Photopolymer-Formulierung durch Vermischen aller Bestandteile hergestellt,

(II) die Photopolymer-Formulierung bei einer Verarbeitungstemperatur in die für das holographische Medium gewünschte Form gebracht und

(III) in der gewünschten Form unter Urethanbildung bei einer Vernetzungstemperatur oberhalb der Verarbeitungstemperatur ausgehärtet wird.

Die Verarbeitungstemperatur kann insbesondere ≥ 15 und ≤ 40 °C und bevorzugt ≥ 18 und ≤ 25 °C sein.

Bevorzugt wird die Photopolymer-Formulierung im Schritt II) in die Form eines Films gebracht. Dazu kann die Photopolymer-Formulierung beispielsweise flächig auf ein Trägersubstrat aufgebracht werden, wobei beispielsweise die dem Fachmann bekannte Vorrichtungen wie eine Rakeleinrichtungen (Doctor Blade, knife-over-Roll, Commabar, u.a) oder eine Schlitzdüse zum Einsatz kommen können.

Als Trägersubstrat kann eine Lage eines für Licht im sichtbaren Spektralbereich (Transmission größer als 85% im Wellenlängenbereich von 400 bis 780 nm) transparenten Materials oder Materialverbunds verwendet werden.

Bevorzugte Materialien oder Materialverbünde des Trägersubstrats basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Besonders bevorzugt basieren sie auf PC, PET und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders

bevorzugt sind PC/PET, PET/PC/PET und PC/TPU (TPU = Thermoplastisches Polyurethan).

Alternativ zu den vorgenannten Trägersubstraten können auch planare Glasplatten eingesetzt werden, die insbesondere für großflächige abbildungsgenaue Belichtungen Verwendung finden, z.B. für holographische Lithographie (Holographic interference lithography for integrated optics. IEEE Transactions on Electron Devices (1978), ED-25(10), 1193-1200, ISSN:0018-9383).

Die Materialien oder Materialverbünde des Trägersubstrats können einseitig oder beidseitig antihaftend, antistatisch, hydrophobiert oder hydrophiliert ausgerüstet sein. Die genannten Modifikationen dienen an der dem Photopolymer zugewandten Seite dem Zweck, dass das Photopolymer von dem Trägersubstrat zerstörungsfrei abgelöst werden kann. Eine Modifikation der dem Photopolymer abgewandten Seite des Trägersubstrats dient dazu, dass die erfindungsgemäßen Medien speziellen mechanischen Anforderungen genügen, die z.B. bei der Verarbeitung in Rollenlaminatoren, insbesondere bei Rolle-zu-Rolle-Verfahren, gefordert sind.

Das Trägersubstrat kann ein- oder beidseitig beschichtet sein.

Die Vernetzungstemperatur kann insbesondere > 60° C und ≤ 100° C und bevorzugt > 70° C und ≤ 95° C und besonders bevorzugt ≥ 75° C und ≤ 90° C sein.

Gegenstand der Erfindung ist auch ein nach dem erfindungsgemäßen Verfahren erhältliches holographisches Medium.

Noch ein weiter Gegenstand der Erfindung ist ein Schichtaufbau, umfassend ein Trägersubstrat, einen darauf aufgebrachten Film aus einer erfindungsgemäßen Photopolymer-Formulierung sowie gegebenenfalls eine auf der dem Trägersubstrat abgewandten Seite des Films aufgebrachte Abdeckschicht.

Der Schichtaufbau kann insbesondere eine oder mehrere Abdeckschichten auf dem Film aufweisen, um diesen vor Schmutz und Umwelteinflüssen zu schützen. Hierzu können Kunststofffolien oder Folienverbundsysteme, aber auch Klarlacke verwendet werden.

Als Abdeckschichten werden bevorzugt Folienmaterialien analog den in dem Trägersubstrat eingesetzten Materialien verwendet, wobei diese eine Dicke von typischerweise 5 bis 200 μm, bevorzugt 8 bis 125 μm, besonders bevorzugt 20 bis 50 μm aufweisen können.

Bevorzugt sind Abdeckschichten mit einer möglichst glatten Oberfläche. Als Maß gilt hier die Rauigkeit, bestimmt nach DIN EN ISO 4288 "Geometrische Produktspezifikation (GPS) - Oberflächenbeschaffenheit..." (engl. "Geometrical Product Specifications (GPS) - Surface texture..."), Prüfbedingung R3z Vorderseite und Rückseite. Bevorzugte Rauigkeiten liegen im Bereich kleiner oder gleich 2 μm, bevorzugt kleiner oder gleich 0,5 μm.

Als Abdeckschichten werden bevorzugt PE- oder PET-Folien einer Dicke von 20 bis 60 μm verwendet. Besonders bevorzugt kommt eine Polyethylenfolie mit einer Dicke von 40 μm zum Einsatz.

Es ist ebenfalls möglich, dass bei einem Schichtaufbau auf dem Trägersubstrat eine weitere Abdeckschicht als Schutzschicht aufgebracht ist.

Die Verwendung eines erfindungsgemäßen holographischen Mediums zur Herstellung eines Hologramms, insbesondere eines In-Line, Off-Axis, Full-Aperture Transfer, Weißlicht-Transmissions, Denisyuk, Off-Axis Reflektions oder Edge-Lit Hologramms sowie eines holographischen Stereogramms ist ebenfalls Gegenstand der Erfindung..

Die erfindungsgemäßen holographischen Medien können durch entsprechende Belichtungsprozesse für optische Anwendungen im gesamten sichtbaren und nahen UV-Bereich (300-800 nm) zu Hologrammen verarbeitet können. Visuelle Hologramme umfassen alle Hologramme, die nach dem Fachmann bekannten Verfahren aufgezeichnet werden können. Darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reflektionshologramme, Edge-Lit Hologramme sowie holographische Stereogramme. Bevorzugt sind Reflexionshologramme, Denisyukhologramme, Transmissionshologramme.

Mögliche optische Funktionen der Hologramme, die mit den erfindungsgemäßen Medien hergestellt werden können entsprechen den optische Funktionen von Lichtelementen wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität, je nachdem wie die Hologramme belichtet wurden und welche Dimensionen das Hologramm hat.

Zudem können mittels der erfindungsgemäßen holographischen Medien auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Design-möglichkeiten stellen Hologramme, insbesondere Volumenhologramme, eine attraktive technische Lösung für die oben genannten Anwendung dar.

Die Erfindung wird im Folgenden anhand von Beispielen näher erläutert.

Sofern nicht abweichend vermerkt, beziehen sich alle Prozentangaben auf Gewichtsprozent.

**Bezeichnungen die im folgenden Verwendung finden:**

Photopolymer-Formulierungen umfassend:

- Dreidimensional vernetzte organische Matrixpolymere A), die als Vorstufen aus
    - einer Polyisocyanat-Komponente a)
    - und einer Isocyanat-reaktiven Polyol-Komponente b) aufgebaut sind und
    - mit Hilfe eines Katalysators c) dreidimensional vernetzt werden;
- Schreibmonomere B), die unter Einwirkung aktinischer Strahlung mit ethylenisch ungesättigten Verbindungen unter Polymerisation reagierende Gruppen (strahlenhärtende Gruppen) aufweisen und in den Matrixpolymeren gelöst oder verteilt vorliegen
- einen Photoinitiator C)
- optional einen Weichmacher D)
- optional ein Lösungsmittel d),

gegebenenfalls Radikalstabilisatoren, Additive sowie andere Hilfs- und / oder Zusatzstoffe E)

**Messmethoden:**

**OH-Zahlen**

Die angegebenen OH-Zahlen wurden gemäß DIN 53240-2 bestimmt.

**NCO-Werte**

Die angegebenen NCO-Werte (Isocyanat-Gehalte) wurden gemäß DIN EN ISO 11909 bestimmt.

**Molekulargewichte**

Die Molekulargewichte wurden mittels Gelpermeationschromatographie (GPC) bestimmt. Die Kalibrierung erfolgt mit Polystyrol-Standards mit einem Molekulargewichten von Mp 1.000.000 bis 162. Als Eluent wird Tetrahydrofuran p.A. verwendet. Die folgenden Parameter werden bei der Doppelmessung eingehalten:

Entgasung: Online - Degasser

Durchfluß: 1 ml/Min.

Analysenzeit: 45 Minuten

Detektoren: Refraktometer und UV-Detektor

Injektionsvolumen: 100 µl - 200 µl

Die Berechnung der Molmassenmittelwerte $M_w$; $M_n$ und $M_p$ sowie der Polydispersität $M_w/M_n$ erfolgt softwaregestützt. Basislinienpunkte und Auswertegrenzen werden entsprechend der DIN 55672 Teil 1 festgelegt.

**Viskositäten**

Für die Bestimmung der Viskosität wurde die zu untersuchende Komponente oder Mischung, wenn nicht anders angegeben, bei 20 °C in einem Kegel-Platte-Messsystem eines Rheometers (Firma Anton Paar Physica Modell MCR 51) aufgetragen. Die Messung wurde bei folgenden Bedingungen durchgeführt:

- Messkörper: Kegel CP 25, d = 25mm, Winkel = 1°
- Messspalt als Abstand zwischen Kegel und Platte: 0,047 mm
- Messdauer: 10 sec.
- Bestimmung der Viskosität bei einer Scherrate von 250 1/sec.

**Festgehalte**

Die Festgehalte wurden bestimmt, indem entweder unter Berücksichtigung der Bedienungsanleitung einer IR-Waage ca. 1 g Substanz auf eine Einweg-Aluschale aufgetragen und bei 140°C solange erhitzt wurden, bis 30 Sekunden Gewichtskonstanz bestand oder ca. 1 g Substanz auf eine spezielle Einweg-Aluschale aufgetragen wurde (geeignet für Systeme mit einem maximalen Lösemittelgehalt von 10 Gew.-%) und bei 125°C für 60 Minuten im Trockenschrank erhitzt wurde. Dabei wurde die zu bestimmende Substanz mithilfe einer geeignet gebogenen Büroklammer so verteilt, dass eine gleichmäßige Trocknung des Film gewährleistet war. Die Büroklammer verblieb zur Messung in der Probe und musste bei der Einwaage berücksichtigt werden.

**Messung des Gelpunktes $G_{Gel}$ und $t_{Gel}$ der Photopolymer-Formulierungen und der Aktivierungstemperatur $T_{Akt}$**

Die Gelpunkte $G_{Gel}$ und $t_{Gel}$ und die Aktivierungstemperaturen $T_{Akt}$ wurden an Formulierungen ohne Photoinitiator bestimmt, da er für die Messungen nicht notwendig ist und die Gelpunkte $G_{Gel}$ und $t_{Gel}$ und die Aktivierungstemperaturen $T_{Akt}$ durch die Anwesenheit des Photoinitiators in der Formulierung nicht beeinflusst werden.

**Messung des Gelpunktes $G_{Gel}$ und $t_{Gel}$ der Photopolymeren mittels eines Oszillationsrheometers**

Zur Herstellung der Photopolymer-Formulierung zur Bestimmung des Gelpunktes $G_{Gel}$ und $t_{Gel}$ wurden die Komponente B), sowie gegebenenfalls Additive in der Polyol-Komponente b) gelöst. Gegebenenfalls wurde maximal 10 Minuten im Trockenschrank auf 60 °C erhitzt. Wenn die Komponenten schon flüssig vorlagen, konnte auf das Erhitzen verzichtet werden. Anschließend wurde die Polyisocyanat-Komponente a) zugegeben und im Speedmixer 1 Minute gemischt. Anschließend wurde eine Lösung der Komponente c) in der Komponente d) zugegeben und im Speedmixer erneut 1 Minute gemischt. Die Konzentration der Komponente c) in Komponente d) betrug 5 oder 10 Gew.-%. Von dieser Lösung wurden die in Tabelle 1 entsprechende beschriebenen Mengen eingesetzt.

Die noch flüssige Formulierung wurde dann in das Platte - Platte Messsystem eines Rheometers (Firma Anton Paar Physica Modell MCR 301 ausgerüstet mit dem Ofenmodel CTD 450, der auf die Temperatur $T$ vorgeheizt war) eingebracht. Dann wurde die Aushärtung der Matrix der Photopolymer-Formulierung über die Zeit unter folgenden Bedingungen gemessen:

- Plattenabstand 250μm.
- Messmodus Oszillation bei einer konstanten Frequenz $f$ von 10 Hz und einer geregelten Deformationsamplitude von 10%.
- Temperatur $T$ bei 303 K oder 313 K oder 328 K oder 343 K oder 353 K, Normalkraftregelung auf 0 Newton eingestellt.
- Aufzeichnung des Speichermoduls G' und des Verlustmoduls G" über der Messzeit $t$ mindestens solange bis die Bedingung des Gelpunktes $G' = G'' = G_{Gel}$ zur Zeit $t_{Gel}$ erreicht wurde.

Figur 1 zeigt beispielhaft den Verlauf der Aushärtung des Matrixnetzwerkes bis über den Gelpunkt hinaus. Es wurde mit der flüssigen Photopolymer-Formulierung, bei der G" > G' gilt, begonnen. Durch die einsetzende Vernetzung erhöhte sich die Elastizität bis der Speichermodul $G' = G'' = G_{Gel}$ zum Zeitpunkt $t_{Gel}$ erreicht wurde. Dies definiert den Gelpunkt. Bei der weiteren fortschreitenden Vernetzung der Matrix blieb dann $G' > G''$.

**Bestimmung der Aktivierungstemperatur $T_{Akt}$ der Photopolymer-Formulierung**

Die Gelzeit $t_{Gel}$ wird von der Temperatur abhängig sein, da zu erwarten ist, dass bei erhöhter Temperatur, bei der die Matrix aushärtet, der Katalysator (Komponente c)) aktiver ist. Daher wurde $t_{Gel}$ bei verschiedenen Temperaturen $T$ für ein und dieselbe Photopolymer-Formulierung bestimmt. Dann wurden die erhaltenen Werte für $t_{Gel}$ gegen die entsprechenden inversen absoluten Temperatur $1/T$, gegeben in 1/K, aufgetragen. Wählt man dafür eine logarithmische Skalierung der $y$-Achse, erhält man eine lineare Abhängigkeit gegeben als:

$$\ln\left(t_{Gel}/\min\right) = T_{Akt}/T + A \qquad \text{Formel (1)}$$

Mittel linearer Regression wurde dann die Aktivierungstemperatur $T_{Akt}$ bestimmt.

Figur 2 zeigt beispielhaft die oben beschriebene Temperaturabhängigkeit von $t_{Gel}$.

**Messung der Schichtdicke der Photopolymerschichten**

Die physikalische Schichtdicke wurde mit dem marktgängigen Weisslichtinterferometer FTM-Lite NIR Schichtdickenmessgerät der Firma Ingenieursbüro Fuchs bestimmt

**<u>Einsatzstoffe</u>**

**Verwendete Polyisocyanat-Komponenten a)**

Isocyanatkomponente 1 (Komponente a1), Desmodur N 3900, ist ein Produkt der Bayer MaterialScience AG, Leverkusen, Deutschland, Hexandiisocyanat-basiertes Polyisocyanat, Anteil an Iminooxadiazindion mindestens 30 %, NCO-Gehalt: 23,5 %

Isocyanatkomponente 2 (Komponente a2), Desmodur XP 2599, ist ein Produkt der Bayer MaterialScience AG, Leverkusen, Deutschland, Vollallophanat von Hexandiisocyanat auf Acclaim 4200, NCO-Gehalt: 5,6 - 6,4 %

Isocyanatkomponente 3 (Komponente a3), Desmodur XP 2747, ist ein Produkt der Bayer MaterialScience AG, Leverkusen, Deutschland, Vollallophanat von Hexandiisocyanat auf Polypropylenglykol mit zahlenmittlerer Molmasse von ca. 280 g/mol, NCO-Gehalt: 16,5 - 17,3 %.

**Verwendete isocyanatreaktive Komponenten (Komponenten b)**

Polyol 1 (Komponente b1) ist ein Produkt der Bayer MaterialScience AG, Leverkusen, Deutschland, die Herstellung ist unten beschrieben.

Polyol 2 (Komponente b2), Acclaim 4200, ist ein Produkt der Bayer MaterialScience AG, Leverkusen, Deutschland, Polypropylenoxid der zahlenmittleren Molmasse 4000 g/Mol

Polyol 3 (Komponente b3) ist ein Produkt der Bayer MaterialScience AG, Leverkusen, Deutschland, die Herstellung ist unten beschrieben.

**Verwendete Acrylate (Komponente B)**

Acrylat 1 (Komponente B1), [1072455-04-9], ist ein Produkt der Bayer MaterialScience AG, Leverkusen, Deutschland, die Herstellung ist unten beschrieben.

Acrylat 2 (Komponente B2), [1207339-61-4], ist ein Produkt der Bayer MaterialScience AG, Leverkusen, Deutschland, die Herstellung ist unten beschrieben.

Acrylat 3 (Komponente B3) ist eine Mischung aus gleichen Gewichtsteilen von Komponente B1) und Komponente B2).

**Verwendete Komponenten der Photoinitiatorsysteme (Komponente C)**

Coinitiator 1 Tetrabutylammonium-tris(3-chlor-4-methylphenyl)(hexyl)borat, [1147315-11-4]) ist ein von der BASF SE, Basel, Schweiz, im Jahr 2010 erhältliches Produkt.

Farbstoff 1 ist Neu Methylenblau [1934-16-3] und wurde von SIGMA-ALDRICH CHEMIE GmbH, Steinheim, Deutschland bezogen.

Farbstoff 2 ist Safranin O [1477-73-6] und wurde von SIGMA-ALDRICH CHEMIE GmbH, Steinheim, Deutschland bezogen.
Farbstoff 3 ist Astrazon Orange G [13056-93-7] und wurde von SIGMA-ALDRICH CHEMIE GmbH, Steinheim, Deutschland bezogen.

**Verwendete nicht photopolymerisierbare Komponenten (Komponente D)**

Die nicht photopolymerisierbare Komponente (Komponente D) ist ein Produkt der Bayer MaterialScience AG, Leverkusen, Deutschland, deren Herstellung ist unten beschrieben.

**Verwendete Katalysatoren (Komponenten c gelöst in Komponente d)**

Katalysator 1 (Komponente c1): Urethanisierungskatalysator Fomrez UL 28, Dimethylbis[(1-oxoneodecl)oxy]stannan, Produkt der Momentive Performance Chemicals, Wilton, CT, USA.
Katalysator 2 (Komponente c2): Urethanisierungskatalysator Fomrez UL 29, Di-n-octylzinn-bis(isooctylmercaptoacetat), Produkt der Momentive Performance Chemicals, Wilton, CT, USA.
Katalysator 3 (Komponente c3): Urethanisierungskatalysator Fomrez UL 38, Dioctylzinn-dineodecanoat, Produkt der Momentive Performance Chemicals, Wilton, CT, USA.
Katalysator 4 (Komponente c4): Urethanisierungskatalysator Fomrez UL 50, Dimethylbis(oleoyloxy)stannan, Produkt der Momentive Performance Chemicals, Wilton, CT, USA.
Katalysator 5 (Komponente c5): Urethanisierungskatalysator Fomrez UL 54, Dimethylzinn-bis(2-ethylhexylmercaptoacetat), Produkt der Momentive Performance Chemicals, Wilton, CT, USA.
Katalysator 6 (Komponente c6): Urethanisierungskatalysator, Dibutylzinndilaurat, Produkt der Sigma Aldrich Co., St. Louis, MO, USA.
Katalysator 7 (Komponente c7): Urethanisierungskatalysator, Butylzinn-tris(2-ethylhexanoat), Produkt der Arkema GmbH, Düsseldorf, Deutschland.
Katalysator 8 (Komponente c8): Urethanisierungskatalysator Eisen [III] - acetylacetonat, Eisen [III] - tris-acetylacetonat, Produkt der Sigma Aldrich Co., St. Louis, MO, USA.
Katalysator 9 (Komponente c9): Urethanisierungskatalysator BorchiKat 24, Bismuth(III) tris(2-ethylhexanoat), Produkt der OMG Borchers GmbH, Langenfeld, Deutschland
Katalysator 10 (Komponente c10): Urethanisierungskatalysator BorchiKat 28, Zinn(II) bis(2-ethylhexanoat), Produkt der OMG Borchers GmbH, Langenfeld, Deutschland
Katalysator 11 (Komponente c11): Urethanisierungskatalysator Zinn-(II)-octoat (CAS 1912-83-0) wurde von BNT Chemicals GmbH, Bitterfeld, Deutschland, bezogen.
Katalysator 12 (Komponente c12): Urethanisierungskatalysator Eisen [III] - acetylacetonat wurde von der Firma Acros Organics BVBA, Geel, Belgien bezogen.

**Verwendete Lösungsmittel (Komponenten d)**

Lösungsmittel 1 (Komponente d1): N-Ethylpyrrolidon

Lösungsmittel 2 (Komponente d2): Butylacetat

Lösungsmittel 3 (Komponente d3): Ethylacetat

**Verwendete Hilf- und Zusatzstoffe (Komponenten E)**

BYK® 310: silikonbasiertes Oberflächenadditiv der Fa. BYK-Chemie GmbH, Wesel, Deutschland (Komponente E1) (Lösung 25%-ig in Xylol)
Desmorapid® Z (Dibutylzinn-dilaurat) ist ein Urethanisierungskatalysator und Produkt der Bayer MaterialScience AG, Leverkusen, Deutschland
DMC-Katalysator: Doppelmetallcyanid-Katalysator auf Basis Zinkhexacyanocobaltat (III), erhältlich nach dem in EP 700 949 A beschriebenen Verfahren.
Irganox 1076 ist Octadecyl 3,5-di-(tert)-butyl-4-hydroxyhydrozimtsäureester [2082-79-3].

**Herstellung der Komponenten**

Herstellung von Polyol 1 (Komponente b1):

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

Herstellung von Polyol 3 (Komponente b3):

In einen mit Rührwerk ausgestatteten 20 L - Reaktionskessel wurden 2475 g eines difunktionellen Polytetrahydrofuranpolyetherpolyols (Equivalentgewicht 325 g/Mol OH) eingewogen und 452,6 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min. wurde für 57 Minuten bei laufender Vakuumpumpe und einem Druck von etwa 0,1 bar von unten Stickstoff durch die Mischung geleitet. Danach wurden mittels Stickstoff ein Druck von 0,5 bar eingestellt und 100 g Ethylenoxid (EO) und 150 g Propylenoxid (PO) parallel zum Start der Polymerisation eingeleitet. Hierbei stieg der Druck auf 2,07 bar. Nach 10 Minuten war der Druck wieder auf 0,68 bar abgefallen und es wurden über einen Zeitraum von 1h 53 min. weitere 5,116 kg EO und 7,558 kg PO als Gemisch bei 2,34 bar zugeleitet. 31 Minuten nach Ende der Epoxid-Dosierung wurde bei einem Restdruck von 2,16 bar Vakuum angelegt und vollständig entgast. Der Produkt wurde durch Zugabe von 7,5 g Irganox 1076 stabilisiert und als leicht trübe, viskose Flüssigkeit erhalten (OH-Zahl 27,1 mg KOH/g, Viskosität bei 25 °C: 1636 mPas).

Herstellung des Acrylates 1 (Komponente B1) (Phosphorthioyltris(oxy-4,1-phenylenimino-carbonyloxyethan-2,1-diyl)-triacrylat):

In einem 500 mL Rundkolben wurden 0.1 g 2,6-Di-tert.-butyl-4-methylphenol, 0.05 g Dibutylzinn-dilaurat (Desmorapid® Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

Herstellung des Acrylates 2 (Komponente B2) 2-({[3-(Methylsulfanyl)phenyl]carbamoyl}-oxy)ethylprop-2-enoat):

In einem 100 mL Rundkolben wurden 0.02 g 2,6-Di-tert.-butyl-4-methylphenol, 0.01 g Desmorapid® Z, 11.7 g 3-(Methylthio)phenylisocyanat vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als hellgelbe Flüssigkeit erhalten.

Herstellung des Photoinitiatorsystems 1 (Komponente C1)

In einem Becherglas wurden im Dunkeln oder unter geeigneter Beleuchtung 0,10 g Farbstoff 1, 0,05 g Farbstoff 2, 0,05 g Farbstoff 3, 1,50 g Coinitiator 1 in 3,50 g N-Ethylpyrrolidon gelöst. Von dieser Lösung wurden die entsprechenden Gewichtsprozente zur Erstellung der Beispielmedien verwendet.

Herstellung der nicht photopolymerisierbaren Komponente (Komponente D) (Bis(2,2,3,3,4,4,5,5,6,6,7,7-dodecafluorheptyl)-(2,2,4-trimethylhexan-1,6-diyl)biscarbamat):

In einem 50 mL Rundkolben wurden 0,02 g Dibutylzinn-dilaurat (Desmorapid Z, Bayer MaterialScience AG, Leverkusen, Deutschland) und 3,6 g 2,4,4-Trimethylhexane-1,6-diisocyanat (Vestanat TMDI, Evonik, Deutschland) vorgelegt und auf 60 °C erwärmt. Anschließend wurden 11,9 g 2,2,3,3,4,4,5,5,6,6,7,7-Dodecafluorheptan-1-ol zugetropft und die Mischung weiter auf 60 °C gehalten, bis der Isocyanatgehalt unter 0,1 % gesunken war. Danach wurde abgekühlt. Das Produkt wurde als farbloses Öl erhalten.

**Herstellung der Photopolymerformulierung ohne Photoinitiator zur Bestimmung des Gelpunktes $G_{Gel}$ und $t_{Gel}$ und der Aktivierungstemperatur $T_{Akt}$.**

Tabelle 1 listet die untersuchten Beispiele der Photopolymer-Formulierungen zur Bestimmung des Gelpunktes $G_{Gel}$ und $t_{Gel}$ und der Aktivierungstemperatur $T_{Akt}$ in ihrer Zusammensetzung auf. Diese Photopolymerformulierungen wurden entsprechend der Vorschrift, die im Abschnitt zur Messung des Gelpunktes $G_{Gel}$ und $t_{Gel}$ der Photopolymeren mittels eines Oszillationsrheometers beschrieben wurde, hergestellt.

| Photopolymer-Formulierung ohne Photoinitiator | Polyisocyanat-Komponente | Anteil (g) | Polyol-Komponente | Anteil (g) | NCO : OH | Schreibmonomer | Anteil (g) | Nichtreaktive Komponente | Anteil (g) | Katalysator | Anteil in der Formulierung (Gew. %) | Lösemittel für den Katalysator | Konzentration der Katalysatorlösung (Gew. %) | Lösemittel für den Photoinitiator | Anteil in der Formulierung (Gew. %) |
|---|---|---|---|---|---|---|---|---|---|---|---|---|---|---|---|
| Vergl 1 | a1 | 0,648 | b1 | 3,499 | 1.02 : 1 | B3 | 3,000 | D | 2,5 | c1 | 0,0300 | d1 | 10 | d1 | 3,5 |
| Vergl 2 | a1 | 0,648 | b1 | 3,499 | 1.02 : 1 | B3 | 3,000 | D | 2,5 | c1 | 0,0300 | d2 | 10 | d1 | 3,5 |
| Vergl 3 | a2 | 0,924 | b2 | 2,751 | 1.02 : 1 | B1 | 1,250 | | | c1 | 0,0500 | d2 | 10 | | |
| Vergl 4 | a2 | 0,950 | b2 | 2,622 | 1.02 : 1 | B1 | 1,250 | | | c1 | 0,0500 | d1 | 10 | d1 | 3,5 |
| Vergl 5 | a2 | 0,996 | b2 | 2,751 | 1.02 : 1 | B1 | 1,250 | | | c1 | 0,0500 | d1 | 10 | | |
| Vergl 6 | a3 | 0,465 | b3 | 3,679 | 1.02 : 1 | B3 | 3,000 | D | 2,5 | c1 | 0,0300 | d2 | 10 | d1 | 3,5 |
| Vergl 7 | a3 | 0,465 | b3 | 3,679 | 1.02 : 1 | B3 | 3,000 | D | 2,5 | c1 | 0,1000 | d2 | 10 | d1 | 3,5 |
| Vergl 8 | a3 | 0,465 | b3 | 3,679 | 1.02 : 1 | B3 | 3,000 | D | 2,5 | c1 | 0,1500 | d2 | 10 | d1 | 3,5 |
| Vergl 9 | a1 | 0,349 | b3 | 3,759 | 1.02 : 1 | B3 | 3,000 | D | 2,5 | c1 | 0,0300 | d2 | 10 | d1 | 3,5 |
| Vergl 10 | a1 | 0,349 | b3 | 3,759 | 1.02 : 1 | B3 | 3,000 | D | 2,5 | c1 | 0,1000 | d2 | 10 | d1 | 3,5 |
| Vergl 11 | a1 | 0,349 | b3 | 3,759 | 1.02 : 1 | B3 | 3,000 | D | 2,5 | c1 | 0,1500 | d2 | 10 | d1 | 3,5 |
| Vergl 12 | a1 | 0,648 | b1 | 3,499 | 1.02 : 1 | B3 | 3,000 | D | 2,5 | c4 | 0,0300 | d1 | 10 | d1 | 3,5 |
| Vergl 13 | a1 | 0,648 | b1 | 3,499 | 1.02 : 1 | B3 | 3,000 | D | 2,5 | c4 | 0,0700 | d1 | 10 | d1 | 3,5 |
| Vergl 14 | a1 | 0,648 | b1 | 3,499 | 1.02 : 1 | B3 | 3,000 | D | 2,5 | c3 | 0,0300 | d1 | 10 | d1 | 3,5 |
| Vergl 15 | a1 | 0,648 | b1 | 3,499 | 1.02 : 1 | B3 | 3,000 | D | 2,5 | c3 | 0,0700 | d1 | 10 | d1 | 3,5 |
| Vergl 16 | a1 | 0,648 | b1 | 3,499 | 1.02 : 1 | B3 | 3,000 | D | 2,5 | c5 | 0,0700 | d1 | 10 | d1 | 3,5 |
| Vergl 17 | a1 | 0,648 | b1 | 3,499 | 1.02 : 1 | B3 | 3,000 | D | 2,5 | c5 | 0,0700 | d1 | 10 | d1 | 3,5 |
| Vergl 18 | a1 | 0,648 | b1 | 3,499 | 1.02 : 1 | B3 | 3,000 | D | 2,5 | c5 | 0,0300 | d2 | 10 | d1 | 3,5 |
| Vergl 19 | a1 | 0,648 | b1 | 3,499 | 1.02 : 1 | B3 | 3,000 | D | 2,5 | c2 | 0,0300 | d1 | 10 | d1 | 3,5 |
| Vergl 20 | a1 | 0,648 | b1 | 3,499 | 1.02 : 1 | B3 | 3,000 | D | 2,5 | c2 | 0,0300 | d2 | 10 | d1 | 3,5 |
| Vergl 21 | a1 | 0,706 | b1 | 3,781 | 1.02 : 1 | B3 | 3,000 | D | 2,5 | c6 | 0,0100 | d2 | 10 | | |
| Vergl 22 | a1 | 0,706 | b1 | 3,781 | 1.02 : 1 | B3 | 3,000 | D | 2,5 | c6 | 0,0600 | d2 | 10 | | |
| Vergl 23 | a1 | 0,667 | b1 | 3,480 | 1.02 : 1 | B3 | 3,000 | D | 2,5 | c11 | 0,0100 | d1 | 10 | d1 | 3,5 |
| Vergl 24 | a1 | 0,595 | b1 | 3,104 | 1.02 : 1 | B3 | 3,000 | D | 2,5 | c11 | 0,0100 | d1 | 10 | d3 | 8,0 |
| Vergl 25 | a1 | 0,667 | b1 | 3,480 | 1.02 : 1 | B3 | 3,000 | D | 2,5 | c12 | 0,0100 | d1 | 10 | d1 | 3,5 |
| Vergl 26 | a1 | 0,595 | b1 | 3,104 | 1.02 : 1 | B3 | 3,000 | D | 2,5 | c12 | 0,0100 | d1 | 10 | d3 | 8,0 |
| Erfin. Ge. 1 | a1 | 0,648 | b1 | 3,499 | 1.02 :1 | B3 | 3,000 | D | 2,5 | c7 | 0,0700 | d1 | 10 | d1 | 3,5 |
| Erfin. Ge. 2 | a1 | 0,594 | b1 | 3,099 | 1.02 : 1 | B3 | 3,000 | D | 2,5 | c7 | 0,0700 | d3 | 10 | d3 | 8,0 |
| Erfin. Ge. 3 | a1 | 0,648 | b1 | 3,499 | 1.02 : 1 | B3 | 3,000 | D | 2,5 | c7 | 0,0700 | d2 | 10 | d1 | 3,5 |
| Erfin. Ge. 4 | a1 | 0,706 | b1 | 3,781 | 1.02 : 1 | B3 | 3,000 | D | 2,5 | c7 | 0,0100 | d1 | 10 | | |
| Erfin. Ge. 5 | a1 | 0,706 | b1 | 3,781 | 1.02 : 1 | B3 | 3,000 | D | 2,5 | c7 | 0,0400 | d1 | 10 | | |
| Erfin. Ge. 6 | a1 | 0,706 | b1 | 3,781 | 1.02 : 1 | B3 | 3,000 | D | 2,5 | c7 | 0,0500 | d1 | 10 | | |
| Erfin. Ge. 7 | a2 | 0,996 | b2 | 2,751 | 1.02 : 1 | B1 | 1,250 | | | c7 | 0,0700 | d1 | 10 | | |
| Erfin. Ge. 8 | a2 | 0,950 | b2 | 2,622 | 1.02 : 1 | B1 | 1,250 | | | c7 | 0,0700 | d1 | 10 | d1 | 3,5 |
| Erfin. Ge. 9 | a3 | 0,465 | b3 | 3,679 | 1.02 : 1 | B3 | 3,000 | D | 2,5 | c7 | 0,0700 | d1 | 10 | d1 | 3,5 |
| Erfin. Ge. 10 | a3 | 0,414 | b3 | 3,279 | 1.02 : 1 | B3 | 3,000 | D | 2,5 | c7 | 0,0700 | d1 | 10 | d3 | 8,0 |
| Erfin. Ge. 11 | a1 | 0,349 | b3 | 3,795 | 1.02 : 1 | B3 | 3,000 | D | 2,5 | c7 | 0,0700 | d1 | 10 | d1 | 3,5 |
| Erfin. Ge. 12 | a1 | 0,311 | b3 | 3,382 | 1.02 : 1 | B3 | 3,000 | D | 2,5 | c7 | 0,0700 | d1 | 10 | d3 | 8,0 |
| Erfin. Ge. 13 | a1 | 0,706 | b1 | 3,781 | 1.02 : 1 | B3 | 3,000 | D | 2,5 | c8 | 0,0100 | d1 | 5 | | |
| Erfin. Ge. 14 | a1 | 0,706 | b1 | 3,781 | 1.02 : 1 | B3 | 3,000 | D | 2,5 | c8 | 0,0500 | d1 | 5 | | |
| Erfin. Ge. 15 | a1 | 0,706 | b1 | 3,781 | 1.02 : 1 | B3 | 3,000 | D | 2,5 | c9 | 0,0100 | d2 | 10 | | |
| Erfin. Ge. 16 | a1 | 0,706 | b1 | 3,781 | 1.02 : 1 | B3 | 3,000 | D | 2,5 | c10 | 0,0100 | d2 | 10 | | |

Tabelle 1: Photopolymer-Formulierung ohne Photoinitiator zur Bestimmung des Gelpunktes $G_{Gel}$ und $t_{Gel}$.

**Aktivierungstemperaturen $T_{Akt}$ der Photopolymer-Formulierungen**

Tabelle 2 stellt die Ergebnisse der Bestimmung der Aktivierungstemperaturen $T_{Akt}$ der Photopolymer-Formulierungen dar.

| Beispiel Typ | Katalysator | Menge Katalysator (Gew. %) | Lösemittel für Katalysator | NCO : OH | Zusätzliches Lösemittel | Menge zusätzliches Lösemittel (Gew. %) | $T_{Akt}$ (K) |
|---|---|---|---|---|---|---|---|
| Vergleich 1 | c1 | 0.03 | d1 | 1.02 : 1 | d1 | 3.5 | 7350 |
| Vergleich 2 | c1 | 0.03 | d2 | 1.02 : 1 | d1 | 3.5 | 6870 |
| Vergleich 3 | c1 | 0.05 | d2 | 1.02 : 1 | | | 7380 |
| Vergleich 4 | c1 | 0.05 | d1 | 1.02 : 1 | d1 | 3.5 | 7860 |
| Vergleich 5 | c1 | 0.05 | d1 | 1.02 : 1 | | | 7720 |
| Vergleich 6 | c1 | 0.03 | d2 | 1.02 : 1 | d1 | 3.5 | 7380 |
| Vergleich 7 | c1 | 0.10 | d2 | 1.02 : 1 | d1 | 3.5 | 7040 |
| Vergleich 8 | c1 | 0.15 | d2 | 1.02 : 1 | d1 | 3.5 | 7220 |
| Vergleich 9 | c1 | 0.03 | d2 | 1.02 : 1 | d1 | 3.5 | 7980 |
| Vergleich 10 | c1 | 0.10 | d2 | 1.02 : 1 | d1 | 3.5 | 7530 |
| Vergleich 11 | c1 | 0.15 | d2 | 1.02 : 1 | d1 | 3.5 | 7600 |
| Vergleich 12 | c4 | 0.03 | d1 | 1.02 : 1 | d1 | 3.5 | 8020 |
| Vergleich 13 | c4 | 0.07 | d1 | 1.02 : 1 | d1 | 3.5 | 7380 |
| Vergleich 14 | c3 | 0.03 | d1 | 1.02 : 1 | d1 | 3.5 | 8020 |
| Vergleich 15 | c3 | 0.07 | d1 | 1.02 : 1 | d1 | 3.5 | 7380 |
| Vergleich 16 | c5 | 0.07 | d2 | 1.02 : 1 | d1 | 3.5 | 6200 |
| Vergleich 17 | c5 | 0.07 | d1 | 1.02 : 1 | d1 | 3.5 | 5950 |
| Vergleich 18 | c5 | 0.03 | d1 | 1.02 : 1 | d1 | 3.5 | 6470 |
| Vergleich 19 | c2 | 0.03 | d1 | 1.02 : 1 | d1 | 3.5 | 6780 |
| Vergleich 20 | c2 | 0.03 | d2 | 1.02 : 1 | d1 | 3.5 | 6420 |
| Vergleich 21 | c6 | 0.01 | d2 | 1.02 : 1 | | | 5290 |
| Vergleich 22 | c6 | 0.06 | d2 | 1.02 : 1 | | | 5690 |
| Vergleich 23 | c11 | 0.01 | d1 | 1.02 : 1 | d1 | 3.5 | 5750 |
| Vergleich 24 | c11 | 0.01 | d1 | 1.02 : 1 | d3 | 8.0 | 5610 |
| Vergleich 25 | c12 | 0.01 | d1 | 1.02 : 1 | d1 | 3.5 | 7540 |
| Vergleich 26 | c12 | 0.01 | d1 | 1.02 : 1 | d3 | 8.0 | 2840 |
| Erfin. Ge. 1 | c7 | 0.07 | d1 | 1.02 : 1 | d1 | 3.5 | 9520 |
| Erfin. Ge. 2 | c7 | 0.07 | d3 | 1.02 : 1 | d3 | 8.0 | 10040 |
| Erfin. Ge. 3 | c7 | 0.07 | d2 | 1.02 : 1 | d1 | 3.5 | 9140 |
| Erfin. Ge. 4 | c7 | 0.01 | d1 | 1.02 : 1 | | | 9260 |
| Erfin. Ge. 5 | c7 | 0.04 | d1 | 1.02 : 1 | | | 9810 |
| Erfin. Ge. 6 | c7 | 0.05 | d1 | 1.02 : 1 | | | 9520 |
| Erfin. Ge. 7 | c7 | 0.07 | d1 | 1.02 : 1 | | | 9220 |
| Erfin. Ge. 8 | c7 | 0.07 | d1 | 1.02 : 1 | d1 | 3.5 | 8770 |
| Erfin. Ge. 9 | c7 | 0.07 | d1 | 1.02 : 1 | d1 | 3.5 | 10040 |
| Erfin. Ge. 10 | c7 | 0.07 | d1 | 1.02 : 1 | d3 | 8.0 | 10330 |
| Erfin. Ge. 11 | c7 | 0.07 | d1 | 1.02 : 1 | d1 | 3.5 | 10020 |
| Erfin. Ge. 12 | c7 | 0.07 | d1 | 1.02 : 1 | d3 | 8.0 | 11380 |
| Erfin. Ge. 13 | c8 | 0.01 | d1 | 1.02 : 1 | | | 8550 |
| Erfin. Ge. 14 | c8 | 0.05 | d1 | 1.02 : 1 | | | 8530 |
| Erfin. Ge. 15 | c9 | 0.01 | d2 | 1.02 : 1 | | | 12540 |
| Erfin. Ge. 16 | c10 | 0.01 | d2 | 1.02 : 1 | | | 9550 |

Tabelle 2: Darstellung der Aktivierungstemperaturen der verschiedenen Photopolymerformulierungen.

**Herstellung von holographischen Medien auf einer Folienbeschichtungsanlage**

Im Folgenden wird die kontinuierliche Herstellung von holographischen Medien in der Form von Filmen aus erfindungsgemäßen und nicht erfindungsgemäßen Photopolymer-Formulierungen beschrieben.

Figur 3 zeigt den schematischen Aufbau der verwendeten Beschichtungsanlage. In der Figur haben die einzelnen Bauteile die folgenden Bezugszeichen:

1 Vorratsbehälter
2 Dosiereinrichtung
3 Vakuumentgasungseinrichtung
4 Filter
5 Statischer Mischer
6 Beschichtungseinrichtung
7 Umlufttrockner
8 Trägersubstrat
9 Abdeckschicht

Zur Herstellung der Photopolymer-Formulierung wurden die Polyol-Komponente b) schrittweise mit den Schreibmonomeren B), den Weichmachern D), dem Katalysator c) und dem oberflächenaktiven Additiv BYK® 310 (Komponente E) versetzt und gemischt. Anschließend wurde eine Lösung der Komponente C) der Mischung im Dunklen hinzugefügt und vermischt, so dass eine klare Lösung erhalten wurde. Wenn nötig, wurde die Formulierung für kurze Zeit bei 60 °C erwärmt, um die Einsatzstoffe schneller in Lösung zu bringen. Dieses Gemisch wurde in einen der beiden Vorratsbehälter 1 der Beschichtungsanlage eingebracht. In den zweiten Vorratsbehälter 1 wurde die Polyisocyanat-Komponente a) eingefüllt. Beide Komponenten wurden dann jeweils durch die Dosiereinrichtungen 2 zur Vakuumentgasungseinrichtung 3 gefördert und entgast. Von hier aus wurden sie dann jeweils durch die Filter 4 in den statischen Mischer 5 geleitet, in dem die Vermischung der Komponenten zur Photopolymer-Formulierung erfolgte. Die erhaltene, flüssige Masse wurde dann der Beschichtungseinrichtung 6 zugeführt.

Bei der Beschichtungseinrichtung handelte 6 handelte es sich im vorliegenden Fall um ein dem Fachmann bekanntes Rakelsystem (Doctor Blade). Alternativ kann aber auch eine Schlitzdüse zum Einsatz kommen. Mit Hilfe der Beschichtungseinrichtung 6 wurde die Photopolymer-Formulierung bei einer Verarbeitungstemperatur von 20 °C auf ein Trägersubstrat 8 in der Form einer 175 μm dicke Polycarbonatfolie appliziert und für 5,8 Minuten bei einer Vernetzungstemperatur von 80°C in einem Umlufttrockner 7 getrocknet. Dabei wurde ein Medium in der Form eines Films erhalten, der dann mit einer 40 μm dicken Polyethylenfolie als Abdeckschicht 9 versehen und aufgewickelt wurde.

Die gewünschte Zielschichtdicke des Films lag vorzugsweise zwischen 10 bis 60 μm, die erzielten Schichtdicken für die hergestellten holographischen Folien sind der Tabelle 3 zu entnehmen.

Die Herstellgeschwindigkeiten lag bevorzugt im Bereich von 0,2 m/min bis 300 m/min und besonders bevorzugt im Bereich vom 1,0 m/min bis 50 m/min.

**Nachweis der Eignung der erfindungsgemäßen Photopolymer-Formulierungen zur Herstellung großtechnischen Herstellung von holographischen Medien in der Form von Filmen**

Bei der kontinuierlichen Herstellung von holographischen Filmen aus einer Photopolymer-Formulierung auf der oben beschriebenen Beschichtungsanlage sind einerseits die Topfzeit der Photopolymer-Formulierung und andererseits deren Reaktionszeit bis zur vollständigen Vernetzung für eine kontinuierliche homogene Beschichtung entscheidend. Beide Aspekte werden nachfolgend erläutert.

1. Topfzeit der Photopolymermischung bei der entsprechenden Verarbeitungstemperatur

Bei der Herstellung kontinuierlicher Filme ist die Topfzeit der Photopolymer-Formulierung mit dem Beginn der Vermischung bis zur Applikation ein sehr wichtiger Faktor. Eine unendlich lange Topfzeit bei der entsprechenden Verarbeitungstemperatur ist bevorzugt, da sie eine störungsfreie Verarbeitung der Formulierung ermöglicht.

Die Bewertung der Topfzeit an einer Beschichtungsanlage erfolgte durch die visuelle Beurteilung der beschichteten Trägersubstrats nach der Beschichtungseinrichtung. Bei einer zu kurzen Topfzeit stieg die Viskosität während des Beschichtungsvorgangs bereits in der Beschichtungseinrichtung signifikant an. Dies führte während des Beschichtungsvorgangs zu einer diffusen Streifenbildung, die im ausgeprägten Fall bis zu signifikant großen unbeschichteten Benetzungsfeldern führen konnte. Des Weiteren können in Längsrichtung verstreckte Photopolymer-Klumpen auf dem Trägersubstrat beobachtet werden. Die Zeit bis solche Effekte zu beobachten waren, stellte eine Maßeinheit zur Beurteilung der Topfzeit unterschiedlicher Systeme dar.

| Beispiel Typ | Katalysator | Menge Katalysator (Gew. %) | Lösemittel für Katalysator | Photoinitiator | Zusätzliches Lösemittel | Menge zusätzliches Lösemittel (Gew. %) | Beschichtungssystem | Schichtdicke (µm) | $T_{Akt}$ (K) | Topfzeit (min) |
|---|---|---|---|---|---|---|---|---|---|---|
| Vergleich 1 | c1 | 0,03 | d1 | C1 | - | - | Rakel | 24 - 26 | 7350 | 15 - 20 |
| Vergleich 1 | c1 | 0,03 | d1 | - | - | - | Rakel | 16 - 18 | 7350 | 15 - 20 |
| Vergleich 4 | c1 | 0,05 | d1 | C1 | - | - | Rakel | 53 - 57 | 7860 | 12 - 15 |
| Erfin. Ge. 1 | c7 | 0,07 | d1 | C1 | - | - | Rakel | 24 - 26 | 9520 | 35 - 40 |
| Erfin. Ge. 2 | c7 | 0,07 | d3 | C1 | d3 | 5,0 | Rakel | 15 - 17 | 10040 | 45 - 55 |
| Erfin. Ge. 2 | c7 | 0,07 | d3 | C1 | d3 | 10,0 | Schlitzdüse | 15 - 17 | 10040 | > 300 |

Tabelle 3: Aktivierungstemperaturen $T_{Akt}$ von Photopolymer-Formulierungen im Vergleich zu deren Topfzeit auf einer Beschichtungsanlage

Die in Tabelle 2 und 3 dargestellten Ergebnisse zeigen, dass Formulierungen mit einer Aktivierungstemperatur $T_{Akt}$ > 8300 K bei Raumtemperatur lange Topfzeiten in der Beschichtungsanlage aufweisen. Dies bedeutet, dass die erfindungsgemäßen Photopolymer-Formulierungen besonders gut für eine effiziente großtechnische Produktion von holographischen Medien in der Form von Filmen geeignet sind.

Die Ergebnisse offenbaren darüber hinaus, dass die Aktivierungstemperatur $T_{Akt}$ unabhängig von der Katalysator-Konzentration in der Photopolymer-Formulierung ist. Daher kann die Katalysator-Konzentration so eingestellt werden, dass bei der relevanten Vernetzungstemperatur eine fest vorgegebene Reaktionszeit erreicht wird, die für die ökonomische Auslegung des Beschichtungsprozesses sinnvoll ist. Eine erfindungsgemäße Photopolymer-Formulierung mit einer großen Aktivierungstemperatur $T_{Akt}$ erreicht dann bei Raumtemperatur eine längere Topfzeit als eine andere, die eine kleinere Aktivierungstemperatur $T_{Akt}$ besitzt.

Überraschenderweise wurde gefunden, dass das Kriterium zur Auswahl eines geeigneten Katalysators für eine Photopolymer-Formulierung im Sinne der Erfindung, die Aktivierungstemperatur $T_{Akt}$ der Reaktion zur Bildung des Matrixnetzwerkes ist, die über die bei verschiedenen Temperaturen $T$ ermittelten Gelzeiten $t_{Gel}$ in einem Oszillationsrheometer bestimmt werden kann. Dies ist deshalb überraschend, da zur Bestimmung der Topfzeit logischerweise der erste Anstieg der Viskosität vom konstanten Niveau der Ausgangsmischung bei der Verarbeitungstemperatur herangezogen würde, da bis dahin die Formulierungen gut verlaufen (Thomas Mezger, "Das Rheologie Handbuch", Vincentz Verlag Hannover, Seite 59) und zur Bestimmung der Zeit zum Erreichen der Wickelfähigkeit oder Blockfestigkeit, die Zeit bis zum Erreichen eines genügend hohen Speichermoduls $G'$ bei der Vernetzungstemperatur. Das heißt, man betrachtet Zeitskalen in rheologisch völlig veschiedenen Zuständen, nämlich flüssig und schon hochvernetzt. Sie hängen darüber hinaus auch von der Konzentration des Katalysators ab, was eine Bewertung im Sinne zur Lösung der Aufgabe erschwert. Der Gelpunkt liegt gerade dazwischen und definiert den Zeitpunkt wann das erste durchgehende vernetzte Makromolekül erhalten wird (Perkolationsschwelle). Offenbar und überraschenderweise enthält gerade diese Gelzeit $t_{Gel}$ mit ihrer Temperaturabhängigkeit, die durch die von der Katalysatorkonzentration unabhängige Größe $T_{Akt}$ ausgedrückt wird, alle notwendigen Informationen zur Lösung der Aufgabe.

2. Reaktionszeit bis zur vollständigen oder ausreichend vollständigen Vernetzung der Photopolymer-Matrix:

Die Reaktionszeit oder Verweilzeit unter bestimmten Bedingungen wie zum Beispiel einer bestimmten Temperatur ist ein wichtiger Faktor, der die Wickelfähigkeit, bzw. Blockfestigkeit des Photopolymers-Film und somit die Produktionsgeschwindigkeit bei der Herstellung solcher Photopolymerfilme signifikant beeinflusst. Eine kurze Reaktionszeit bei der Vernetzungstemperatur wird daher bevorzugt.

Für die Bewertung der Wickelfähigkeit sind zwei Merkmale beim fertigen Produkt maßgeblich. Zum Einen ist die Homogenität der Photopolymer-Filmdicke visuell wichtig. Die Randbereiche des Photopolymers in Laufrichtung der Bahn sind hierbei besonders auffällig und gut zu beurteilen. Hier können zumeist leichte Unebenheiten in den Schichtdicken durch die Einfärbung des Photopolymers beobachtet werden, die durch eine Verschiebung des Materials bei

Druckaufgabe durch die Schutzfolie entstehen können.

Als weiterer Aspekt ist die Klebrigkeit des Photopolymer-Films von Bedeutung. Um diese zu beurteilen, wird die Abdeckschicht von dem Photopolymer-Film abgezogen. Während des Vorgangs kann über die aufgebrachte Kraft zum Abziehen und der Beobachtung der Grenzfläche zwischen Photopolymer und Abdeckschicht die Klebrigkeit empirisch ermittelt werden. Hierbei ist die mögliche Zerstörung des Photopolymer-Films beim Abziehen ein besonders starkes Anzeichen für eine starke Haftung zwischen Photopolymer und Abdeckschicht, was wiederum durch eine zu geringe Blockfestigkeit des Polymers hervorgerufen wird.

Physikalisch gesehen ist die für eine gute Wickelfähigkeit die Ausbildung eines genügend hohen Speichermoduls G' durch die dreidimensionale Vernetzung des Matrixpolymers der Photopolymer-Formulierung ausschlaggebend.

Der Vergleich der Filme der erfindungsgemäßen Beispiele 1 bis 3 mit denen der Vergleichsbeispielen 1 bis 4 zeigte, dass trotz der erheblich längeren Topfzeit bei identischen Aushärtungsbedingungen auch aus den erfindungsgemäßen Photopolymer-Formulierungen Filme mit sehr guter Wickelfähigkeit erhalten wurden. So waren diese Filme sehr homogen und ließen sich leicht und ohne Beschädigung von der Abdeckschicht trennen.

## Patentansprüche

1. Photopolymer-Formulierung umfassend wenigstens eine Polyol-Komponente, eine Polyisocyanat-Komponente, ein Schreibmonomer, einen Photoinitiator und einen Katalysator, **dadurch gekennzeichnet, dass** die Photopolymer-Formulierung eine Aktivierungstemperatur ≥ 8300 K aufweist, wobei die Aktivierungstemperatur bestimmt wird, indem aus der Polyol-Komponente, der Polyisocyanat-Komponente, dem Schreibmonomer und dem Katalysator eine Mischung hergestellt, von der Mischung jeweils das Speichermodul *G*' und das Verlustmodul *G*" über eine Messzeit *t*, mindestens bis die Bedingung des Gelpunktes $G' = G'' = G_{Gel}$ zur Zeit $t_{Gel}$ erreicht ist, bei Temperaturen *T* = 303 K, 313 K, 328 K, 343 K und 353 K mit einem Platte - Platte Messsystem eines Rheometers bei einem Plattenabstand von 250 μm im Messmodus Oszillation bei einer konstanten Frequenz *f* von 10 Hz und einer geregelten Deformationsamplitude von 10% bestimmt, eine logarithmische Auftragung von $t_{Gel}$ gegen die jeweilige inverse absolute Temperatur 1/T, bei der $t_{Gel}$ bestimmt wurde, erstellt und aus der Auftragung mittels linearer Regression die Aktivierungstemperatur gemäß der Formel

$$\ln\left(t_{Gel}/\min\right) = T_{Akt}\ /T + A$$

als Steigung der Geraden ermittelt wird.

2. Photopolymer-Formulierung nach Anspruch 1, **dadurch gekennzeichnet, dass** die Aktivierungstemperatur > 8700 K, bevorzugt > 9000 K, besonders bevorzugt > 9300 K und ganz besonders bevorzugt ≥ 9500 K ist.

3. Photopolymer-Formulierung nach einem der Ansprüche 1 oder 2, **dadurch gekennzeichnet, dass** die Polyolkomponente primäre OH-Gruppen aufweist und bevorzugt ein difunktioneller Polyether- oder Polyester oder ein Polyether-Polyester-Blockcopolymer mit primären OH-Gruppen ist.

4. Photopolymer-Formulierung nach einem der Ansprüche 1 bis 3, **dadurch gekennzeichnet, dass** die Polyisocyanat-Komponente ein aliphatisches Polyisocyanat oder ein aliphatisches Präpolymer und bevorzugt ein aliphatisches Polyisocyanat oder Präpolymer mit primären NCO-Gruppen ist.

5. Photopolymer-Formulierung nach einem der Ansprüche 1 bis 4, **dadurch gekennzeichnet, dass** das Schreibmonomer wenigstens ein monofunktionelles und ein multifunktionelles Urethan(meth)acrylat umfasst.

6. Photopolymer-Formulierung nach einem der Ansprüche 1 bis 5, **dadurch gekennzeichnet, dass** der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

7. Photopolymer-Formulierung nach einem der Ansprüche 1 bis 6, **dadurch gekennzeichnet, dass** sie zusätzlich Weichmacher, bevorzugt Weichmacher gemäß der allgemeinen Formel (VI)

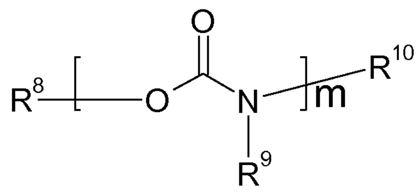

(VI)

umfasst, in der m≥1 und m≤8 ist und $R^8$, $R^9$, $R^{10}$ Wasserstoff und / oder unabhängig voneinander lineare, verzweigte, cyclische oder heterocyclische unsubstituierte oder gegebenenfalls auch mit Heteroatomen substituierte organische Reste sind, wobei bevorzugt mindestens einer der Reste $R^8$, $R^9$, $R^{10}$ mit wenigstens einem Fluoratom substituiert ist und besonders bevorzugt $R^8$ ein organischer Rest mit mindestens einem Fluoratom ist.

**8.** Photopolymer-Formulierung nach einem der Ansprüche 1 bis 7, **dadurch gekennzeichnet, dass** der Katalysator die allgemeine Formel (II)

$RSnL_3$ (II)

aufweist, in der
R ein linearer oder verzweigter, gegebenenfalls mit Heteroatomen, insbesondere mit Sauerstoff, auch in der Kette substituierter Alkylrest mit 1 - 30 C-Atomen ist und
L jeweils unabhängig voneinander $-O_2C-R^3$ Gruppen sind, bei denen $R^3$ ein linearer oder verzweigter, gegebenenfalls mit Heteroatomen, insbesondere mit Sauerstoff, auch in der Kette substituierter Alkylrest mit 1 - 30 C-Atomen, ein Alkenylrest mit 2 - 30 C-Atomen oder ein beliebiger substituierter oder unsubstituierter gegebenenfalls polycyclischer aromatischer Ring mit oder ohne Heteroatomen ist.

**9.** Photopolymer-Formulierung nach Anspruch 8, **dadurch gekennzeichnet, dass** R ein linearer oder verzweigter Alkylrest mit 1 - 12 C-Atomen, besonders bevorzugt ein Methyl-, Ethyl-, Propyl, *n*-, *i*-, *t*-Butyl-, *n*-Octyl-Rest und ganz besonders bevorzugt ein *n*-, *i*-, *t*-Butyl-Rest ist und / oder $R^3$ ein linearer oder verzweigter, gegebenenfalls mit Heteroatomen, insbesondere mit Sauerstoff, auch in der Kette substituierter AlkylRest mit 1 - 17 C-Atomen oder Alkenyl-Rest mit 2 - 17 C-Atomen, besonders bevorzugt ein linearer oder verzweigter Alkyl- oder Alkenylrest mit 3 - 13 C-Atomen, ganz besonders bevorzugt ein linearer oder verzweigter Alkyl- oder Alkenylrest mit 5 - 11 C-Atomen ist und insbesondere alle L gleich sind.

**10.** Photopolymer-Formulierung nach einem der Ansprüche 1 bis 7, **dadurch gekennzeichnet, dass** der Katalysator die allgemeine Formel (III) oder (IV)

$Bi(III)M_3$ (III),

$Sn(II)M_2$ (IV),

aufweist, in der M jeweils unabhängig voneinander $-O_2C-R^4$ Gruppen sind, bei denen $R^4$ ein gesättigter oder ungesättiger oder mit Heteroatomen substituierter $C_1$- bis $C_{19}$-Alkylrest oder $C_2$- bis $C_{19}$ Alkenylrest, insbesondere ein $C_6$- bis $C_{11}$-Alkylrest und besonders bevorzugt ein $C_7$- bis $C_9$-Alkylrest oder ein gegebenenfalls aromatisch oder mit Sauerstoff oder Stickstoff beliebig substituierter $C_1$- bis $C_{18}$-Alkylrest ist, wobei in den Formel (III) und (IV) M nicht gleichbedeutend sein muss.

**11.** Photopolymer-Formulierung nach einem der Ansprüche 1 bis 7, **dadurch gekennzeichnet, dass** der Katalysator die allgemeine Formel (V)

$FeQ_3$ (V),

in der Q jeweils unabhängig voneinander organische Anionen der Formel (Va) sind,

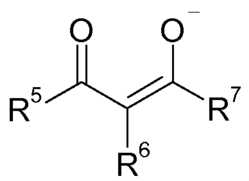

(Va)

bei denen $R^5$ und $R^7$ jeweils unabhängig voneinander ein gegebenenfalls mit Heteroatomen substituierter $C_1$- bis $C_{18}$-Alkylrest oder $C_2$-$C_{18}$ Alkenylrest, insbesondere ein $C_1$- bis $C_{10}$-Alkylrest und besonders bevorzugt ein $C_1$- bis $C_4$-Alkylrest ist oder $R^5$ und $R^6$ gemeinsam eine Brücke, beispielsweise aus $-CH_2-CH_2-CH_2-$, $-CH_2-CH_2-CH_2-CH_2-$, $-CH_2-CH_2-CH_2-CH_2-CH_2-$, -CH=CH-CH=CH- bilden oder ein gegebenenfalls mit Heteroatomen substituierter aromatischer oder heteroaromatischer Ring sind und $R^6$ Methyl oder Wasserstoff ist

**12.** Photopolymer-Formulierung nach den Ansprüchen 8 bis 11, **dadurch gekennzeichnet, dass** der Katalysator aus der Gruppe der Verbindungen der Formeln (II), (III), (IV) und/oder (V) ausgewählt ist.

**13.** Verfahren zur Herstellung eines holographischen Mediums, bei dem

(I) eine Photopolymer-Formulierung gemäß einem der Ansprüche 1 bis 12 durch Vermischen aller Bestandteile hergestellt,
(II) die Photopolymer-Formulierung bei einer Verarbeitungstemperatur in die für das holographische Medium gewünschte Form gebracht und
(III) in der gewünschten Form unter Urethanbildung bei einer Vernetzungstemperatur oberhalb der Verarbeitungstemperatur ausgehärtet wird.

**14.** Verfahren nach Anspruch 13, **dadurch gekennzeichnet, dass** die Photopolymer-Formulierung im Schritt II) in die Form eines Films gebracht wird.

**15.** Verfahren nach Anspruch 14, **dadurch gekennzeichnet, dass** die Photopolymer-Formulierung flächig auf ein Trägersubstrat aufgebracht wird.

**16.** Verfahren nach einem der Ansprüche 13 bis 15, **dadurch gekennzeichnet, dass** die Verarbeitungstemperatur $\geq$ 15 und $\leq$ 40 °C, bevorzugt $\geq$ 18 und $\leq$ 25 °C ist.

**17.** Verfahren nach einem der Ansprüche 13 bis 16, **dadurch gekennzeichnet, dass** die Vernetzungstemperatur $\geq$ 60 und $\leq$ 100 °C, ist.

**18.** Holographisches Medium, erhältlich nach einem Verfahren gemäß einem der Ansprüche 13 bis 17.

**19.** Verwendung eines holographischen Mediums nach Anspruch 18 zur Herstellung eines Hologramms, insbesondere eines In-Line, Off-Axis, Full-Aperture Transfer, Weißlicht-Transmissions, Denisyuk, Off-Axis Reflektions oder Edge-Lit Hologramms sowie eines holographischen Stereogramms.

## Claims

**1.** Photopolymer formulation comprising at least a polyol component, a polyisocyanate component, a writing monomer, a photoinitiator and a catalyst, **characterized in that** the photopolymer formulation has an activation temperature $\geq$ 8300 K, wherein the activation temperature is determined by using the polyol component, the polyisocyanate component, the writing monomer and the catalyst to prepare a mixture; determining both the storage modulus $G'$ and the loss modulus $G''$ of the mixture over a measurement time $t$, at least until the condition of the gel point $G' = G'' = G_{Gel}$ at time $t_{Gel}$ is reached, at temperatures $T$ = 303 K, 313 K, 328 K, 343 K and 353 K using a plate-plate measuring system of a rheometer at a plate spacing of 250 $\mu$m in the oscillation mode at a constant frequency $f$ of 10 Hz and a regulated deformation amplitude of 10%; establishing a logarithmic plot of $t_{Gel}$ versus the respective inverse absolute temperature 1/T at which $t_{Gel}$ was determined; and using linear regression to determine the activation temperature $T_{Akt}$ as per the formula

$$\ln(t_{Gel}/\min) = T_{Akt}/T + A$$

as the slope of the straight line in the plot.

2. Photopolymer formulation according to Claim 1, **characterized in that** the activation temperature is ≥ 8700 K, preferably ≥ 9000 K, more preferably ≥ 9300 K and even more preferably ≥ 9500 K.

3. Photopolymer formulation according to either of Claims 1 and 2, **characterized in that** the polyol component has primary OH groups and preferably is a difunctional polyether or polyester or a polyether-polyester block copolymer having primary OH groups.

4. Photopolymer formulation according to any of Claims 1 to 3, **characterized in that** the polyisocyanate component is an aliphatic polyisocyanate or an aliphatic prepolymer and preferably an aliphatic polyisocyanate or prepolymer having primary NCO groups.

5. Photopolymer formulation according to any of Claims 1 to 4, **characterized in that** the writing monomer comprises at least one monofunctional and one multifunctional urethane (meth)acrylate.

6. Photopolymer formulation according to any of Claims 1 to 5, **characterized in that** the photoinitiator comprises a combination of dyes by whose absorption spectra the spectral region from 400 to 800 nm is at least partly covered with at least one coinitiator adapted to the dyes.

7. Photopolymer formulation according to any of Claims 1 to 6, **characterized in that** it further comprises plasticizers, preferably plasticizers as per general formula (VI)

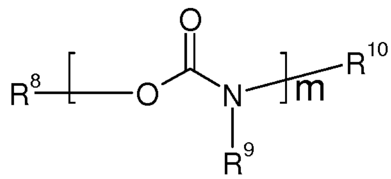

(VI)

where m is ≥ 1 and ≤ 8 and $R^8$, $R^9$, $R^{10}$ are hydrogen and/or independently of each other linear, branched, cyclic or heterocyclic unsubstituted or else optionally heteroatom-substituted organic radicals, wherein preferably at least one of $R^8$, $R^9$, $R^{10}$ is substituted with at least a fluorine atom and more preferably $R^8$ is an organic radical having at least one fluorine atom.

8. Photopolymer formulation according to any of Claims 1 to 7, **characterized in that** the catalyst has the general formula (II)

$RSnL_3$ (II)

where
R is a linear or branched alkyl radical of 1 - 30 carbon atoms which is optionally substituted with heteroatoms, especially with oxygen, even in the chain, and
each L is independently of the others an $-O_2C-R^3$ group wherein $R^3$ is a linear or branched alkyl radical of 1 - 30 carbon atoms which is optionally substituted with heteroatoms, especially with oxygen, even in the chain, an alkenyl radical of 2 - 30 carbon atoms or any desired substituted or unsubstituted optionally polycyclic aromatic ring with or without heteroatoms.

9. Photopolymer formulation according to Claim 8, **characterized in that** R is a linear or branched alkyl radical of 1 - 12 carbon atoms, more preferably a methyl, ethyl, propyl, *n*-, *i*-, *t*-butyl, *n*-octyl radical and even more preferably an *n*-, *i*-, *t*-butyl radical and/or $R^3$ is a linear or branched alkenyl radical of 2 - 17 carbon atoms or alkyl radical of 1 - 17 carbon atoms optionally substituted with heteroatoms, especially with oxygen, even in the chain, more preferably

a linear or branched alkyl or alkenyl radical of 3 - 13 carbon atoms and even more preferably a linear or branched alkyl or alkenyl radical of 5 - 11 carbon atoms and more particularly each L is the same.

**10.** Photopolymer formulation according to any of Claims 1 to 7, **characterized in that** the catalyst has the general formula (III) or (IV)

$Bi(III)M_3$ (III),

$Sn(II)M_2$ (IV),

where each M is independently of the others an $O_2C$-$R^4$ group wherein $R^4$ is a saturated or unsaturated or heteroatom-substituted $C_1$- to $C_{19}$-alkyl radical or $C_2$- to $C_{19}$ alkenyl radical, especially a $C_6$- to $C_{11}$-alkyl radical and more preferably a $C_7$- to $C_9$-alkyl radical or is a $C_1$- to $C_{18}$-alkyl radical which is optionally substituted aromatically or with oxygen or nitrogen in any desired form, wherein M in the formulae (III) and (IV) need not have the same meaning.

**11.** Photopolymer formulation according to any of Claims 1 to 7, **characterized in that** the catalyst the general formula (V)

$FeQ_3$ (V),

where each Q is independently of the others an organic anion of formula (Va),

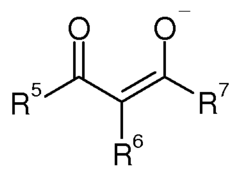

(Va)

where $R^5$ and $R^7$ are each independently of each other an optionally heteroatom-substituted $C_1$- to $C_{18}$-alkyl radical or $C_2$-$C_{18}$ alkenyl radical, especially a $C_1$- to $C_{10}$-alkyl radical and more preferably a $C_1$- to $C_4$-alkyl radical or $R^5$ and $R^6$ combine to form a bridge, for example from $-CH_2-CH_2-CH_2-$, $-CH_2-CH_2-CH_2-CH_2-$, $-CH_2-CH_2-CH_2-CH_2-CH_2-$, - CH=CH-CH=CH-, or an optionally heteroatom-substituted aromatic or heteroaromatic ring and $R^6$ is methyl or hydrogen.

**12.** Photopolymer formulation according to Claims 8 to 11, **characterized in that** the catalyst is selected from the group of compounds of formulae (II), (III), (IV) and/or (V).

**13.** Process for producing a holographic medium wherein

(I) a photopolymer formulation according to any of Claims 1 to 12 is prepared by mixing all constituents,
(II) the photopolymer formulation is processed at a processing temperature into the form desired for the holographic medium, and
(III) is cured in the desired form by urethane formation at a crosslinking temperature above the processing temperature.

**14.** Process according to Claim 13, **characterized in that** the photopolymer formulation is processed in step II) into the form of a film.

**15.** Process according to Claim 14, **characterized in that** the photopolymer formulation is applied flat to a carrier substrate.

**16.** Process according to any of Claims 13 to 15, **characterized in that** the processing temperature is $\geq$ 15 and $\leq$ 40°C, preferably $\geq$ 18 and $\leq$ 25°C.

**17.** Process according to any of Claims 13 to 16, **characterized in that** the crosslinking temperature is $\geq$ 60 and $\leq$ 100°C.

**18.** Holographic medium obtainable by a process according to any of Claims 13 to 17.

**19.** Use of a holographic medium according to Claim 18 for producing a hologram, especially an in-line, off-axis, full-aperture transfer, white light transmission, Denisyuk, off-axis reflection or edge-lit hologram and also a holographic stereogram.

**Revendications**

**1.** Formulation de photopolymère comprenant au moins un composant polyol, un composant polyisocyanate, un monomère d'enregistrement, un photo-initiateur et un catalyseur, **caractérisé en ce que** la formulation de photopolymère présente une température d'activation ≥ 8300 K, la température d'activation étant déterminée **en ce qu'**on prépare, à partir du composant polyol, du composant polyisocyanate, du monomère d'enregistrement et du catalyseur, un mélange, on détermine, sur le mélange, à chaque fois le module d'accumulation G' et le module de perte G" sur un temps de mesure t, au moins jusqu'à ce que la condition du point de gel G' = G" = $G_{Gel}$ au temps $t_{Gel}$ soit atteinte, à des températures T = 303 K, 313 K, 328 K, 343 K et 353 K à l'aide d'un système de mesure plaque-plaque d'un rhéomètre à une distance entre les plaques de 250 μm dans le mode de mesure oscillation à une fréquence constante f de 10 Hz et à une amplitude de déformation régulée de 10%, on établit une représentation logarithmique $t_{Gel}$ par rapport à chaque température absolue inversée 1/T à laquelle $t_{Gel}$ a été déterminée et on détermine, à partir de la représentation, par régression linéaire, la température d'activation selon la formule

$$\ln\left(t_{Gel}/\min\right) = T_{Akt}/T + A$$

comme pente de la droite.

**2.** Formulation de photopolymère selon la revendication 1, **caractérisée en ce que** la température d'activation est ≥ 8700 K, de préférence ≥ 9000 K, de manière particulièrement préférée ≥ 9300 K et de manière tout particulièrement préférée ≥ 9500 K.

**3.** Formulation de photopolymère selon l'une quelconque des revendications 1 ou 2, **caractérisée en ce que** le composant polyol présente des groupes OH primaires et est de préférence un polyéther difonctionnel ou un polyester difonctionnel ou un copolymère séquencé de polyéther-polyester présentant des groupes OH primaires.

**4.** Formulation de photopolymère selon l'une quelconque des revendications 1 à 3, **caractérisée en ce que** le composant polyisocyanate est un polyisocyanate aliphatique ou un prépolymère aliphatique et de préférence un polyisocyanate aliphatique ou un prépolymère aliphatique présentant des groupes NCO primaires.

**5.** Formulation de photopolymère selon l'une quelconque des revendications 1 à 4, **caractérisée en ce que** le monomère d'enregistrement comprend au moins un uréthane-(méth)acrylate monofonctionnel et au moins un uréthane-(méth)acrylate multifonctionnel.

**6.** Formulation de photopolymère selon l'une quelconque des revendications 1 à 5, **caractérisée en ce que** le photo-initiateur comprend une combinaison de colorants, dont les spectres d'absorption recouvrent au moins partiellement la plage spectrale de 400 à 800 nm, avec au moins un co-initiateur adapté aux colorants.

**7.** Formulation de photopolymère selon l'une quelconque des revendications 1 à 6, **caractérisée en ce qu'**elle comprend en outre des plastifiants, de préférence des plastifiants selon la formule générale (VI)

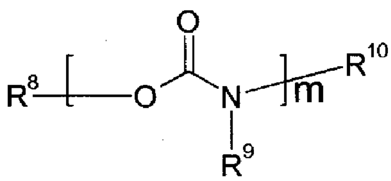

(VI)

dans laquelle m ≥ 1 et m ≤ 8 et $R^8$, $R^9$, $R^{10}$ représentent hydrogène et/ou, indépendamment les uns des autres, des radicaux organiques linéaires, ramifiés, cycliques ou hétérocycliques, non substitués ou le cas échéant également substitués par des hétéroatomes, au moins un des radicaux $R^8$, $R^9$, $R^{10}$ étant de préférence substitué par au moins un atome de fluor et $R^8$ représentant de manière particulièrement préférée un radical organique comprenant au moins un atome de fluor.

8. Formulation de photopolymère selon l'une quelconque des revendications 1 à 7, **caractérisée en ce que** le catalyseur présente la formule générale (II)

$RSnL_3$ (II)

dans laquelle

R représente un radical alkyle linéaire ou ramifié, le cas échéant substitué par des hétéroatomes, en particulier par de l'oxygène, également dans la chaîne, comprenant 1-30 atomes de carbone et
L représentent, à chaque fois indépendamment les uns des autres, des groupes $-O_2C-R^3$, dans lesquels $R^3$ représente un radical alkyle linéaire ou ramifié, le cas échéant substitué par des hétéroatomes, en particulier par de l'oxygène, également dans la chaîne, comprenant 1-30 atomes de carbone, un radical alcényle comprenant 2-30 atomes de carbone ou un quelconque cycle aromatique le cas échéant polycyclique, substitué ou non substitué, avec ou sans hétéroatomes.

9. Formulation de photopolymère selon la revendication 8, **caractérisée en ce que** R représente un radical alkyle linéaire ou ramifié comprenant 1-12 atomes de carbone, de manière particulièrement préférée un radical méthyle, éthyle, propyle, n-butyle, i-butyle, t-butyle, n-octyle et de manière tout particulièrement préférée un radical n-butyle, i-butyle, t-butyle et/ou $R^3$ représente un radical alkyle comprenant 1-17 atomes de carbone ou un radical alcényle comprenant 2-17 atomes de carbone, linéaire ou ramifié, le cas échéant substitué par des hétéroatomes, en particulier par de l'oxygène, également dans la chaîne, de manière particulièrement préférée un radical alkyle ou alcényle linéaire ou ramifié comprenant 3-13 atomes de carbone, de manière tout particulièrement préférée un radical alkyle ou alcényle linéaire ou ramifié comprenant 5-11 atomes de carbone et, en particulier, tous les L sont identiques.

10. Formulation de photopolymère selon l'une quelconque des revendications 1 à 7, **caractérisée en ce que** le catalyseur présente la formule générale (III) ou (IV)

$Bi(III)M_3$ (III),

$Sn(II)M_2$ (IV),

dans lesquelles M représentent, à chaque fois indépendamment les uns des autres, des groupes $-O_2C-R^4$, dans lesquels $R^4$ représente un radical $C_1$-$C_{19}$-alkyle ou $C_2$-$C_{19}$-alcényle saturé ou insaturé ou substitué par des hétéroatomes, en particulier un radical $C_6$-$C_{11}$-alkyle et de manière particulièrement préférée un radical $C_7$-$C_9$-alkyle ou un radical $C_1$-$C_{18}$-alkyle le cas échéant substitué de manière quelconque de manière aromatique ou par de l'oxygène ou de l'azote, M ne devant pas présenter la même signification dans la formule (III) et la formule (IV).

11. Formulation de photopolymère selon l'une quelconque des revendications 1 à 7, **caractérisée en ce que** le catalyseur présente la formule générale (V)

$FeQ_3$ (V),

dans laquelle Q représentent, à chaque fois indépendamment les uns des autres, des anions organiques de formule (Va),

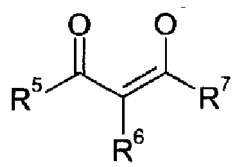
(Va)

dans laquelle $R^5$ et $R^7$ représentent, à chaque fois indépendamment l'un de l'autre, un radical $C_1$-$C_{18}$-alkyle ou $C_2$-$C_{18}$-alcényle le cas échéant substitué par des hétéroatomes, en particulier un radical $C_1$-$C_{10}$-alkyle et de manière particulièrement préférée un radical $C_1$-$C_4$-alkyle ou $R^5$ et $R^6$ forment ensemble un pont, par exemple $-CH_2-CH_2-CH_2-$, $-CH_2-CH_2-CH_2-CH_2-$, $-CH_2-CH_2-CH_2-CH_2-CH_2-$, $-CH=CH-CH=CH-$, ou représentent un cycle aromatique ou hétéroaromatique le cas échéant substitué par des hétéroatomes et $R^6$ représente méthyle ou hydrogène.

12. Formulation de photopolymère selon les revendications 8 à 11, **caractérisée en ce que** le catalyseur est choisi dans le groupe des composés des formules (II), (III), (IV) et/ou (V).

13. Procédé pour la fabrication d'un agent holographique, dans lequel

(I) on prépare une formulation de photopolymère selon l'une quelconque des revendications 1 à 12 par mélange de tous les constituants,
(II) on amène la formulation de photopolymère à une température de mise en oeuvre dans la forme souhaitée pour l'agent holographique et
(III) on durcit dans la forme souhaitée avec formation d'uréthane à une température de réticulation supérieure à la température de mise en oeuvre.

14. Procédé selon la revendication 13, **caractérisé en ce que** la formulation de photopolymère dans l'étape II) est amenée dans la forme d'un film.

15. Procédé selon la revendication 14, **caractérisé en ce que** la formulation de photopolymère est appliquée à plat sur un substrat support.

16. Procédé selon l'une quelconque des revendications 13 à 15, **caractérisé en ce que** la température de mise en oeuvre est $\geq$ 15 et $\leq$ 40°C, de préférence $\geq$ 18 et $\leq$ 25°C.

17. Procédé selon l'une quelconque des revendications 13 à 16, **caractérisé en ce que** la température de réticulation est $\geq$ 60 et $\leq$ 100°C.

18. Agent holographique, pouvant être obtenu selon un procédé selon l'une quelconque des revendications 13 à 17.

19. Utilisation d'un agent holographique selon la revendication 18 pour la réalisation d'un hologramme, en particulier d'un hologramme en ligne, hors axe, par transfert à ouverture complète (Full-Aperture Transfer), par transmission de lumière blanche, de Denisyuk, par réflexion hors axe ou par éclairage périphérique ainsi que d'un stéréogramme holographique.

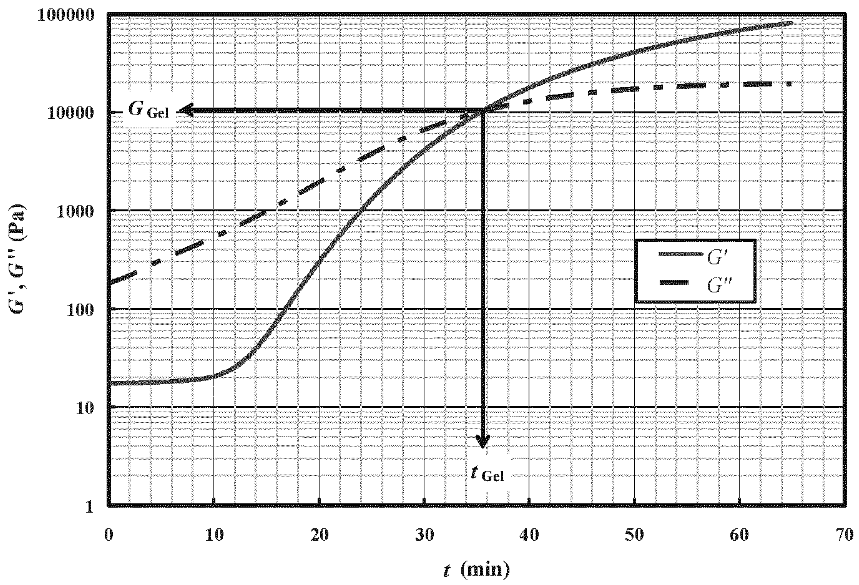


Figur 1: Zeitlicher Verlauf der Aushärtung des Matrixnetzwerkes von flüssigen Zustand bis über den Gelpunkt hinaus. Gemessen wird der Speichermodul *G'* und der Verlustmodul *G''* über der Aushärtezeit *t* bei fester Temperatur *T*.

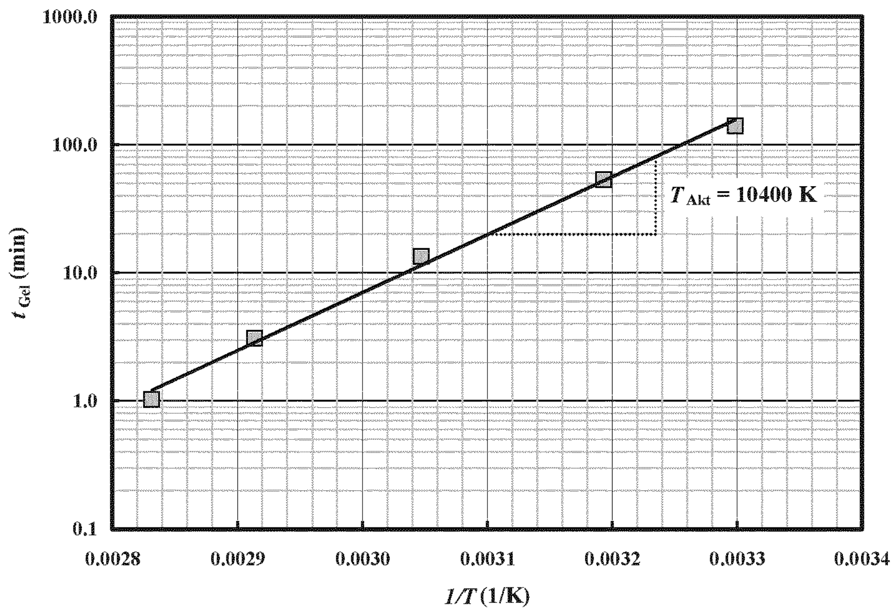


Figur 2: Arrhenius-Darstellung der Gelzeit $t_{Gel}$ gegen die inverse absolute Temperatur $1/T$. Aus der Steigung des linearen Zusammenhanges des natürlichen Logarithmus von $t_{Gel}$ mit $1/T$ erhält man nach Formel (1) die Aktivierungstemperatur $T_{Akt}$.

**Figur 3:**

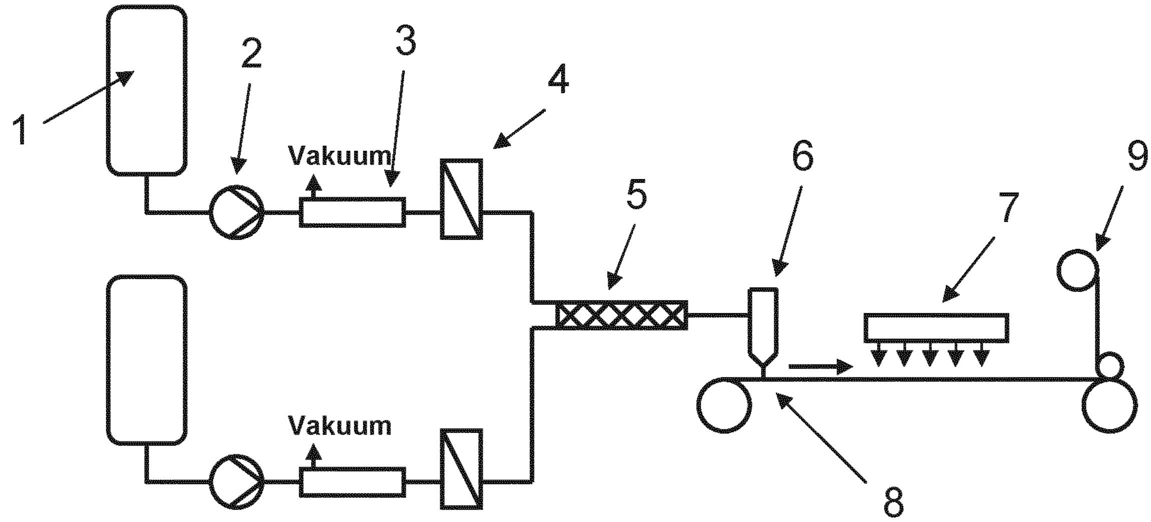


Figur 3: Schematischer Aufbau einer verwendeten kontinuierlichen Film-Beschichtungsanlage (als Rolle-zu-Rolle-Verfahren)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- EP 2172502 A1
- EP 2172505 A1
- WO 03102959A1 A
- EP 2218744 A
- WO 03102959 A1
- EP 0223587 A
- EP 700949 A


### In der Beschreibung aufgeführte Nicht-Patentliteratur


- **P. HARIHARAN.** Optical Holography. Cambridge University Press, 1996
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- Chemistry & Technology of UV & EB Formulations For Coatings, Inks & Paints. SITA Technology, 1991, vol. 3, 61-328
- **H. BERNETH.** Ullmann's Encyclopedia of Industrial Chemistry, Cationic Dyes. Wiley-VCH Verlag, 2008
- **H. BERNETH.** Ullmann's Encyclopedia of Industrial Chemistry, Azine Dyes. Wiley-VCH Verlag, 2008
- **H. BERNETH.** Ullmann's Encyclopedia of Industrial Chemistry, Methine Dyes and Pigments. Wiley-VCH Verlag, 2008
- **T. GESSNER ; U. MAYER.** Ullmann's Encyclopedia of Industrial Chemistry, Triarylmethane and Diarylmethane Dyes. Wiley-VCH Verlag, 2000
- *IEEE Transactions on Electron Devices,* 1978, vol. ED-25 (10), 1193-1200